# EUROPEAN PATENT APPLICATION

(11) **EP 4 770 388 A1**
(43) Date of publication of application: **01.07.2026**
(21) Application number: 25227401.4
(22) Date of filing: 29.12.2025
(51) Int. Cl.: H10K 59/38, H10K 59/80

(54) **DISPLAY DEVICE, ELECTRONIC DEVICE, AND METHOD FOR MANUFACTURING DISPLAY DEVICE**

(30) Priority: 30.12.2024 KR 20240200599
(71) Applicant: Samsung Display Co., Ltd., Yongin-si, Gyeonggi-do (KR)
(72) Inventor: Choe, Wonkyu, Yongin-si, Gyeonggi-do (KR)
(74) Representative: Gulde & Partner

(57) **Abstract**

Provided is a display device (DD) including a base layer (BS) including a non-display region (DA) (NDA), and a display region (DA) that includes a first light-emitting region (PXA-B), a second light-emitting region (PXA-G), and a non-light-emitting region (NPXA), a display element layer (EDL) above the base layer (BS) and including a light-emitting element (ED), and an optical layer (PP) above the display element layer (EDL) and including a first color filter (CF-B) overlapping the first light-emitting region (PXA-B), a scattering pattern (SP1, SP2) overlapping the second light-emitting region (PXA-G) and including scattering particles, a second color filter (CF-G) overlapping the second light-emitting region (PXA-G) above the scattering pattern (SP1, SP2), and a light-blocking layer (BM) overlapping the non-light-emitting region (NPXA) between the first color filter (CF-B) and the second color filter (CF-G), and partially covering an upper surface (U-CB) of the first color filter (CF-B).

## Description

### BACKGROUND

The present disclosure herein relates to a display device with improved manufacturing process efficiency and display quality, as well as increased resolution, an electronic device including the same, and a method for manufacturing the display device.

Various display devices used for multimedia devices, such as a television, a mobile phone, a tablet computer, a navigation system, and a game console, are being developed. When using the display devices, a color difference phenomenon may occur according to a viewing angle, which results in a decrease in a display quality of a display device. For this reason, various methods are being introduced to improve a color shift phenomenon according to a viewing angle.

### SUMMARY

The invention is defined by the appended claims. The description that follows is subjected to this limitation. Any disclosure lying outside the scope of said claims is only intended for illustrative as well as comparative purposes.

The present disclosure provides a display device that is capable of implementing high resolution, and that has improved display quality, and an electronic device including the same.

The present disclosure also provides a method for manufacturing a display device with improved manufacturing process efficiency.

One or more embodiments of the present disclosure provide a display device including a base layer including a non-display region, and a display region that includes a first light-emitting region, a second light-emitting region, and a non-light-emitting region, a display element layer above the base layer and including a light-emitting element, and an optical layer above the display element layer and including a first color filter overlapping the first light-emitting region, a scattering pattern overlapping the second light-emitting region and including scattering particles, a second color filter overlapping the second light-emitting region above the scattering pattern, and a light-blocking layer overlapping the non-light-emitting region between the first color filter and the second color filter, and partially covering an upper surface of the first color filter.

According to one or more embodiments of the present disclosure, it may therefore be possible to form high-resolution patterns and reduce variation in horn-shaped operation that occurs at an overlapping section between a scattering pattern and a light-blocking layer, since the disclosure enables a color filter formed in a light-emitting area where there is no scattering pattern to be formed by a photolithography process, and to form another color filter formed in another light-emitting area where a scattering pattern is present by an ink printing process, whereby the coating uniformity of the ink during an inkjet process can be improved.

As used herein, terms such as "above", "below", "upper", "lower", "top", "bottom", and the like may be used to describe relative positional relationships between respective layers, surfaces, and elements and for ease of description with reference to the drawings. For example, an "upper surface" of an element may refer to a surface that faces away from the base layer of the device, whereas a "lower surface" may refer to an opposite surface facing toward the base layer. Similarly, when one element is described as being "above" another element, this may mean that the one element is disposed farther away from the base layer than the other element, regardless of the absolute orientation of the device in space. Positional terms may be intended to describe relative relationships between elements as illustrated in the figures, and should not be construed as absolute limitations on the orientation or placement of the elements in practice.

As used herein, in a display device, a light-emitting region may be formed as an area in which light generated by one or more light-emitting elements is emitted toward a viewer in order to produce an image. Adjacent to such regions, a non-light-emitting region may be provided, which does not itself emit light but may serve for structural stability, routing of electrodes or circuits, or optical adjustment.

A purpose and function of the scattering pattern may be to scatter incident light so as to improve luminance uniformity, enlarge the viewing angle, or reduce visual artifacts.

For the realization of color images, a color filter may be introduced so as to transmit light of predetermined wavelengths while absorbing or blocking other wavelengths, thereby enabling selective color reproduction.

The light that forms the image may originate from a light-emitting element, which may be a component capable of generating visible radiation.

To further enhance display quality, a light-blocking layer may be provided, which suppresses transmission of light through undesired areas, increases contrast, and prevents optical interference between adjacent pixels or subpixels.

As used herein, the expression "overlapping" may mean that, for example when viewed in a top-down projection (a direction extending in a third direction or a plan view), respective regions of the first color filter, the first light-emitting region, the scattering pattern, the second light-emitting region, the second color filter, the light-blocking layer, the non-light-emitting region and further overlapping elements are disposed such that they at least partially occupy a common plan-view area such that the regions at least partially overlap. In some embodiments, the overlap may be complete, i.e., the regions are coextensive in plan view and exactly coincide in position, thereby forming a complete mutual overlap in the plan view.

In other words, the first color filter may be formed (e. g. by a photolithography process) in a same plane as the scattering patterns. As a result, the first color filter and the scattering patterns may be coplanar, such that a step height at a boundary with the light-blocking layer is reduced. By alleviating a horn-shaped variation of the light-blocking layer, ink accumulation during a subsequent inkjet process can be suppressed, thereby improving coating uniformity and display quality. Unlike the first color filter, the second color filter can be formed by inkjet printing. Forming all color filters by photolithography would require multiple additional exposure and etching steps, increasing cost, process complexity, and material consumption. Since the second color filter may be less critical in terms of optical transmission and process difficulty, inkjet printing provides a more efficient and economical fabrication method, while photolithography is reserved for the first filter to ensure precision where it is most needed.

According to one embodiment, the first color filter may overlap only the first light-emitting region, the scattering pattern may overlap only the second light-emitting region, the second color filter may overlap only the second light-emitting region above the scattering pattern, and/or the light-blocking layer may overlap only the non-light-emitting region between the first color filter and the second color filter

According to another embodiment, the scattering pattern may be located in the second light-emitting region in which light having relatively longer wavelengths than that of the first light-emitting region is emitted. Because the scattering pattern overlaps the second light-emitting region, light incident onto the second color filter is scattered, and thus color differences or luminance differences according to a viewing angle may be reduced. Therefore, display quality may be improved.

According to another embodiment, the scattering pattern may be located (directly or indirectly) under the second color filter. When the scattering pattern is located directly under the second color filter, the scattering pattern contacts the second color filter.

According to another embodiment, the scattering pattern may be free of a separate colorant (for example, a pigment or a dye), and may include scattering particles that scatter light within a range (e.g., predetermined range). The scattering pattern may include the scattering particles to scatter at least a portion of light generated from a corresponding light-emitting element.

According to another embodiment, the light-blocking layer may be not above the second color filter. In other words, the light-blocking layer may not be placed (e. g. not even partially) on top of the second color filter or may not cover the top of the second color filter partially or entirely. Further, the light-blocking layer may not be placed below the second color filter or may not partially or completely cover a bottom of the second color filter.

According to another embodiment, the light-blocking layer may partially cover an upper surface of the scattering pattern or may not cover an upper surface of the scattering pattern at all.

According to another embodiment, the scattering pattern may further include a photosensitive material. A photosensitive material may be a substance that undergoes a physical or chemical change when exposed to light, usually in the ultraviolet (UV) or visible spectrum.

According to another embodiment, the scattering pattern may not overlap the first light-emitting region. In other words, the scattering pattern may not be placed within the first light-emitting region or may not cover the first light-emitting region partially or entirely.

According to another embodiment, the scattering pattern may not overlap (in other words may not be located in or may be omitted from) the first light-emitting region that may be a region in which light having a relatively short wavelength is emitted among the light-emitting regions. Light having a relatively short wavelength may refer to electromagnetic radiation within the visible spectrum whose wavelength is shorter compared to other visible wavelengths, e. g. compared to the second light-emitting region. In particular, short-wavelength visible light may denote the blue or blue to violet region, typically in the range of about 380 nm to 500 nm.

According to another embodiment, at least two of a lower surface of the first color filter, a lower surface of the scattering pattern, and a lower surface of the light-blocking layer may be coplanar.

According to another embodiment, a lower surface of the first color filter, a lower surface of the scattering pattern, and a lower surface of the light-blocking layer may be coplanar. That may mean that bottom surfaces of the first color filter, of the scattering pattern, and of the light-blocking layer may lie substantially within a common geometric plane, such that the respective surfaces extend along the same reference plane without step differences. Coplanarity in this context may not require perfect mathematical identity of the planes but may allow for manufacturing tolerances within industry-accepted limits.

According to another embodiment, the scattering pattern may be spaced apart from the first color filter with the light-blocking layer between the scattering pattern and the first color filter. In other words, there may be a gap between the scattering pattern and the first color filter, with the light-blocking layer being arranged within the gap. The light-blocking layer may contact the scattering pattern and the first color filter.

According to another embodiment, a thickness variation of the first color filter may be less than a thickness variation of the second color filter. In other words, an amount of thickness fluctuation (or unevenness) in the first color filter may be smaller than an amount of thickness fluctuation in the second color filter. In other words, when you compare how much the thickness of each color filter deviates from its intended or average thickness, the first one may have less variation (more uniform thickness), while the second one may show greater variation.

According to another embodiment, a first opening corresponding (in other words assigned) to the first light-emitting region, and a second opening corresponding (in other words assigned) to the second light-emitting region may be defined in the light-blocking layer, wherein, in a first direction perpendicular to a thickness direction, a width of the first color filter is greater than a width of the first opening, and/or a width of the second color filter is substantially equal to a width of the second opening. The thickness direction may refer to a direction perpendicular to a main extension plane of the light-blocking layer or in other words, to a direction normal to a main surface of the base layer. In the context of a display device, the thickness direction may correspond to a stacking direction in which multiple functional layers are successively arranged one above another. In other words, the light-blocking layer includes the first opening and the second opening or may form it.

According to another embodiment, the color filters may be respectively located within the corresponding openings or portions thereof defined in the light-blocking layer.

According to another embodiment, the light-blocking layer may be located between the color filters, and may contact each of the color filters.

According to another embodiment, the first color filter and/or the second color filter may be located within the corresponding first and second opening of the light-blocking layer and may be entirely surrounded by a side surface of the light-blocking layer defining the corresponding opening which contacts the corresponding color filter.

According to another embodiment, the first opening may have a first portion and a second portion located above the first portion, wherein, in a first direction perpendicular to a thickness direction, a width of the first portion is greater than a width of the second portion. Further, the first color filter may be located within the first portion and may be entirely surrounded by the light-blocking layer (in other words by a side surface of the light-blocking layer which contacts the first color filter). In other words, the first opening of the light-blocking layer may have a stepped shape. Following, an edge of the light-blocking layer may partially overlap the first color filter on a plane.

According to another embodiment, the second opening may have a first portion and a second portion located above the first portion, wherein, in a first direction perpendicular to a thickness direction, a width of the first portion is greater than a width of the second portion. Further, the second color filter may be located within the second portion and may be entirely surrounded by the light-blocking layer (in other words by a side surface of the light-blocking layer which contacts the second color filter). In other words, the second opening of the light-blocking layer may have a stepped shape. Following, an edge of the light-blocking layer may not overlap the second color filter on a plane. Further, the scattering pattern may be located within the first portion and may be entirely surrounded by the light-blocking layer (in other words by a side surface of the light-blocking layer which contacts the scattering pattern).

According to another embodiment, in the first direction, a width of the first color filter may be greater than a width of the second color filter.

According to another embodiment, the first color filter and the second color filter may be non-coplanar. In other words, the first color filter and the second color filter may be disposed in different planes or may be arranged in a stepped configuration, such that the lower surfaces thereof are non-coplanar.

According to another embodiment, the scattering pattern or a portion thereof may be located within the second opening or portions thereof defined in the light-blocking layer.

According to another embodiment, in the first direction, a width of the scattering pattern or the portion thereof may be substantially equal to or greater than a width of the second opening.

According to another embodiment, in the first direction, a width of the scattering pattern or the portion thereof may be substantially equal to a width of the first color filter.

According to another embodiment, the first light-emitting region may be configured to emit light having a first wavelength, wherein the second light-emitting region is configured to emit light having a second wavelength that is longer (in other words greater) than the first wavelength.

According to another embodiment, the display region may further include a third light-emitting region, wherein the scattering pattern overlaps the second light-emitting region and the third light-emitting region, and wherein the optical layer further includes a third color filter overlapping the third light-emitting region above the scattering pattern.

According to another embodiment, the scattering pattern may include a first scattering pattern overlapping the second light-emitting region, and a second scattering pattern overlapping the third light-emitting region and spaced apart from the first scattering pattern with the light-blocking layer between the first scattering pattern and the second scattering pattern.

According to another embodiment, the display device may further include an encapsulation layer between the display element layer and the optical layer.

According to another embodiment, the scattering pattern and the first color filter may be directly on the encapsulation layer, wherein the second color filter is directly on the scattering pattern.

According to another embodiment, the display device may further include a touch sensor between the encapsulation layer and the optical layer.

According to another embodiment, the optical layer may further include an overcoat layer covering (entirely or partially) an upper surface of the first color filter, an upper surface of the second color filter, and an upper surface of the light-blocking layer.

In one or more embodiments of the present disclosure, an electronic device includes a display module including a display panel, and an optical layer above the display panel, and a housing accommodating the display module, wherein the display panel includes a base layer including a non-display region, and a display region that includes a first light-emitting region, a second light-emitting region, and a non-light-emitting region, and a display element layer above the base layer and including a light-emitting element, wherein the optical layer includes a first color filter overlapping the first light-emitting region, a scattering pattern overlapping the second light-emitting region and including scattering particles, a second color filter overlapping the second light-emitting region above the scattering pattern, and a light-blocking layer overlapping the non-light-emitting region between the first color filter and the second color filter, and covering, at least partially, an upper surface of the first color filter.

In one or more embodiments of the present disclosure, a method for manufacturing a display device includes preparing a substrate defining a first light-emitting region and a second light-emitting region, and forming an optical layer above the substrate by forming a first color filter overlapping the first light-emitting region by patterning a first preliminary color filter including a photosensitive material, forming a scattering pattern overlapping the second light-emitting region, forming a light-blocking layer defining a first opening overlapping the first light-emitting region, and a second opening overlapping the second light-emitting region, and forming a second color filter above the scattering pattern in the second opening through an inkjet process.

According to one embodiment, the forming of the scattering pattern may be before the forming of the light-blocking layer, and may include forming a preliminary scattering pattern including a photosensitive material and scattering particles, and patterning the preliminary scattering pattern.

According to another embodiment, the forming of the scattering pattern may be after the forming of the light-blocking layer, and includes providing, within the second opening, a scattering composition including scattering particles before the forming of the second color filter.

According to another embodiment, the forming of the scattering pattern may be performed before the forming of the light-blocking layer, and the forming of the scattering pattern may include forming a preliminary scattering pattern that includes a photosensitive material and scattering particles, and patterning the preliminary scattering pattern.

According to another embodiment, a first mask may be located on the first preliminary color filter to pattern the first preliminary color filter.

According to another embodiment, the forming the scattering pattern may include patterning a preliminary scattering pattern including a photosensitive material or the scattering pattern may be formed through an inkjet process. In other words, the preliminary scattering pattern may be patterned through a photolithography process or an inkjet process. In the first variant, a second mask may be located on the preliminary scattering pattern to pattern the preliminary scattering pattern. In the second variant, the forming the scattering pattern may include providing a scattering composition including scattering particles into the second opening. Further the scattering composition provided into the second opening may be dried or cured.

According to another embodiment, the forming the light-blocking layer may include forming a preliminary light-blocking layer on a substrate, and forming, by patterning the preliminary light-blocking layer, the light-blocking layer in which the openings respectively overlapping the corresponding light-emitting regions are defined. The preliminary light-blocking layer may be formed on the substrate, and then the light-blocking layer may be formed by patterning each of the openings.

According to another embodiment, the light-blocking layer may be formed to partially overlap the first color filter on a plane. Additionally, the light-blocking layer may be formed to partially overlap the scattering pattern on a plane.

According to another embodiment, the forming the second color filter may include providing a first ink into the second opening through an inkjet process, and then forming the second color filter by drying or curing the first ink.

In one or more embodiments, the forming of the scattering pattern may be performed after the forming of the light-blocking layer, and the forming of the scattering pattern may include providing, within the second opening, a scattering composition that includes scattering particles before the forming of the second color filter.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:
FIG. 1 is a perspective view illustrating an electronic device according to one or more embodiments of the present disclosure;
FIG. 2 is an exploded perspective view of an electronic device according to one or more embodiments of the present disclosure;
FIG. 3 is a block diagram of an electronic device according to embodiments of the present disclosure;
FIG. 4 is a view illustrating electronic devices according to various embodiment;
FIG. 5 is a perspective view of a display module according to one or more embodiments of the present disclosure;
FIG. 6 is a cross-sectional view of a display module according to one or more embodiments of the present disclosure;
FIG. 7 is a cross-sectional view of a display panel according to one or more embodiments of the present disclosure;
FIG. 8 is a cross-sectional view of a display panel DP according to one or more embodiments of the present disclosure;
FIG. 9A is an enlarged cross-sectional view illustrating a partial region of a display module according to one or more embodiments of the present disclosure;
FIG. 9B is an enlarged cross-sectional view of a portion of some components of a display module according to one or more embodiments of the present disclosure;
FIG. 10A is an enlarged cross-sectional view illustrating a partial region of a display module according to one or more embodiments of the present disclosure;
FIG. 10B is an enlarged cross-sectional view of a portion of some components of a display module according to one or more embodiments of the present disclosure;
FIGS. 11A and 11B are enlarged cross-sectional views illustrating a partial region of a display module according to one or more embodiments of the present disclosure;
FIG. 12 is a flowchart of a method for manufacturing a display device according to one or more embodiments of the present disclosure;
FIG. 13 is a flowchart of some steps in a method for manufacturing a display device according to one or more embodiments of the present disclosure;
FIGS. 14A to 14J are cross-sectional views illustrating some steps in a method for manufacturing a display device according to one or more embodiments of the present disclosure;
FIG. 15 is a flowchart of some steps in a method for manufacturing a display device according to one or more embodiments of the present disclosure;
FIGS. 16A to 16H are cross-sectional views illustrating some steps in a method for manufacturing a display device according to one or more embodiments of the present disclosure;
FIGS. 17A and 17B are cross-sectional views for describing limitation that may occur in a display module according to Comparative Example; and
FIGS. 18A and 18B are cross-sectional views of some components of a display module according to one or more embodiments of the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer, or section described below could be termed a second element, component, region, layer, or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same." In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

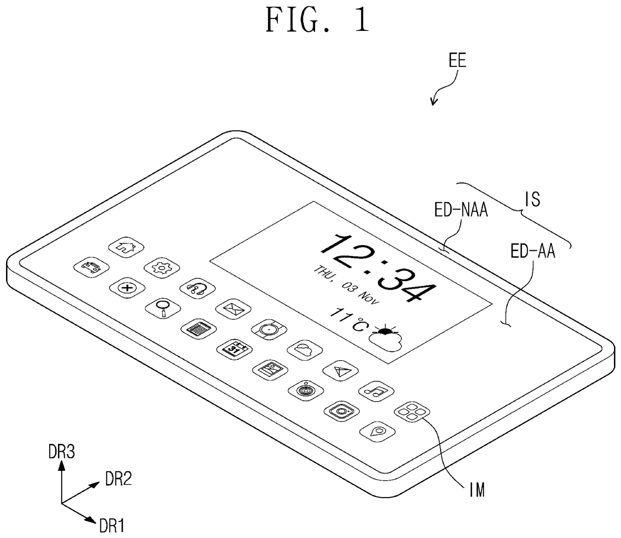

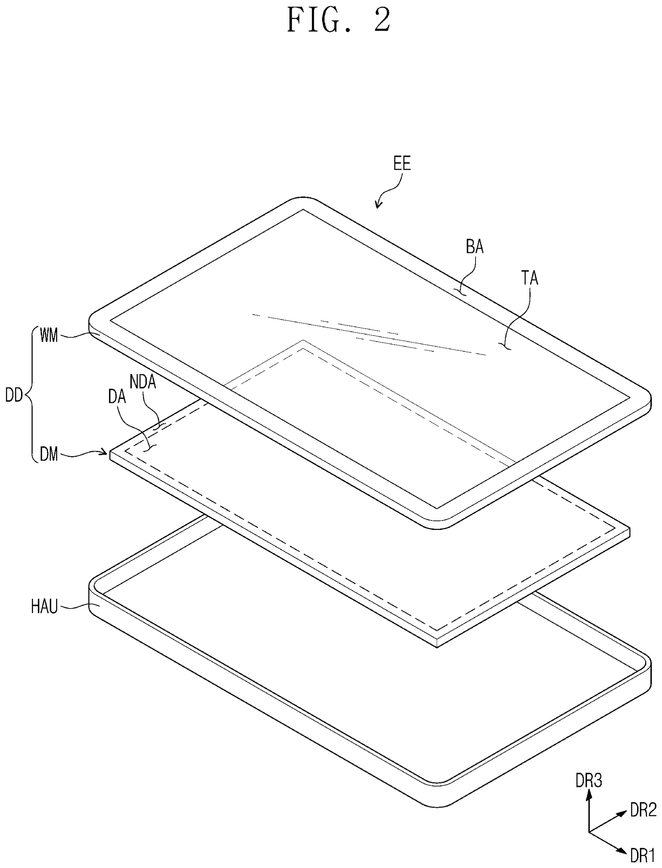

FIG. 1 is a perspective view of an electronic device according to one or more embodiments of the present disclosure. FIG. 2 is an exploded perspective view of an electronic device according to one or more embodiments of the present disclosure.

An electronic device EE according to one or more embodiments may be a display device that is activated in response to an electrical signal and that displays an image. The electronic device EE may include various embodiments. For example, the electronic device EE may include a large-sized device, such as a television or an outdoor billboard, as well as a medium- and small-sized device, such as a monitor, a mobile phone, a tablet computer, a navigation unit, or a game console. Here, the embodiments of the electronic device EE are presented as examples, and are not limited to any one embodiment as long as not departing from the idea of the present disclosure.

In FIG. 1 and the following drawings, a first direction DR1 to a third direction DR3 are illustrated, and directions indicated by the first to third directions DR1, DR2, and DR3 described herein have a relative concept, and may thus be changed to other directions.

In this specification, a thickness direction of the electronic device EE may be parallel to the third direction DR3 that is a normal direction of the plane defined by the first direction DR1 and the second direction DR2. In this specification, a front surface (or an upper surface) and a rear surface (or a lower surface) of each of members constituting the electronic device EE may be defined with respect to the third direction DR3.

The electronic device EE may display an image IM in the third direction DR3 through a display surface IS parallel to a plane defined by the first direction DR1 and the second direction DR2. The third direction DR3 may be parallel to the normal direction of the display surface IS. The display surface IS on which the image IM is displayed may correspond to a front surface of the electronic device EE. The image IM may include not only a dynamic image but also a static image. In FIG. 1, application icons are illustrated as the image IM.

In this specification, the wording "on a plane" or "in plan view" may be defined as a state when viewed in the third direction DR3. In this specification, the wording "on a cross section" may be defined as a state when viewed in the first direction DR1 and/or the second direction DR2. Directions indicated by the first to third directions DR1, DR2, and DR3 have a relative concept, and may thus be changed to other directions.

FIG. 1 illustrates the electronic device EE including a flat display surface IS. However, a form of the display surface IS of the electronic device EE is not limited thereto, and may be curved or three-dimensional.

The electronic device EE may be a flexible electronic device. The wording "flexible" means having a bendable property, and may include all of a completely foldable structure as well as a structure that is bendable to the level of several nanometers. For example, the flexible electronic device EE may include a curved electronic device, or a foldable electronic device.

The display surface IS of the electronic device EE may include an active region ED-AA and a peripheral region ED-NAA. The image IM may be viewed by a user through the active region ED-AA. In one or more embodiments illustrated in FIG. 1, etc., the active region ED-AA is illustrated as having a rectangular shape, but the active region ED-AA may have various shapes in one or more other embodiments.

The peripheral region ED-NAA may be a non-display portion in which the image IM is not displayed. The peripheral region ED-NAA may be a portion that has a color (e.g., predetermined color) and blocks light. The peripheral region ED-NAA may be adjacent to the active region ED-AA. For example, the peripheral region ED-NAA may be located in the outer periphery of at least one side of the active region ED-AA, and the peripheral region ED-NAA may surround the active region ED-AA (e.g. in plan view). However, in one or more embodiments, the peripheral region ED-NAA may be adjacent to only one side of the active region ED-AA, or may be located on a side surface of the electronic device EE instead of a front surface thereof. The present disclosure is not limited thereto, and the peripheral region ED-NAA may also be omitted.

The peripheral region ED-NAA of one or more embodiments may detect an external input applied from the outside. The external input may have various forms, such as pressure, temperature, light, etc., applied from the outside. The external input may include an input applied when being in contact (for example, a touch by a user's hand or a pen) with the electronic device EE, as well as an input (for example, hovering) applied while approaching the electronic device EE.

Referring to FIG. 2, an electronic device EE may include a display device DD and a housing HAU. The display device DD may include a display module DM and a window WM located on the display module DM. The housing HAU may be coupled to the display device DD to define an exterior of the electronic device EE. The housing HAU may provide an inner space in which components, such as the display module DM may be accommodated.

The window WM may be located on the display module DM. The window WM may protect the display module DM against external impacts. A front surface of the window WM may correspond to the display surface IS of the electronic device EE. The front surface of the window WM may include a transmission region TA and a bezel region BA.

The transmission region TA of the window WM may be an optically transparent region. The window WM may transmit an image provided from the display module DM through the transmission region TA, and the corresponding image may be viewed by a user. The transmission region TA may correspond to an active region ED-AA of the electronic device EE.

The window WM may include an optically transparent insulating material. For example, the window WM may include glass, sapphire, or plastic. The window WM may have a single- or multi-layered structure. The window WM may further include functional layers, such as an anti-fingerprint layer, a phase control layer, and a hard coating layer, which are located on an optically transparent substrate.

The bezel region BA of the window WM may be provided as a region on which a material including a color (e.g., predetermined color) is deposited, coated, or printed. The bezel region BA of the window WM may reduce or prevent visibility of some components of the display module DM, which overlap the bezel region BA, from the outside. The bezel region BA may correspond to the peripheral region ED-NAA of the electronic device EE.

The display module DM may display an image in response to an electrical signal. The display module DM may include a display region DA, and a non-display region NDA adjacent to the display region DA.

The display region DA may correspond to the active region ED-AA of the electronic device EE. The display region DA may be a region that is activated in response to an electrical signal. The display region DA may be a region through which an image provided from the display module DM is displayed. The display region DA of the display module DM may correspond to the above-described transmission region TA. In this specification, the wording "a region/portion corresponds to a region/portion" may mean "overlapping each other," and is not limited as having the same area and/or shape. The image displayed on the display region DA may be viewed from the outside through the transmission region TA.

The non-display region NDA may be adjacent to the display region DA. For example, the non-display region NDA may surround the display region DA. However, the present disclosure is not limited thereto, and the non-display region NDA may be defined as having various shapes. The non-display region NDA may correspond to the peripheral region ED-NAA of the electronic device EE. The non-display region NDA may be a region in which a driving circuit for driving the display region DA, various signal lines providing electrical signals, and pads are located. The non-display region NDA of the display module DM may correspond to the above-described bezel region BA. The bezel region BA may reduce or prevent visibility of components of the display module DM of the non-display region NDA from the outside.

The housing HAU may be located below the display module DM, and may accommodate the display module DM. The housing HAU may absorb an impact applied from the outside, and may reduce or prevent infiltration of foreign substances/moisture, etc., into the display module DM, thereby protecting the display module DM. The housing HAU according to one or more embodiments may be provided in a form in which a plurality of accommodation members are coupled to each other.

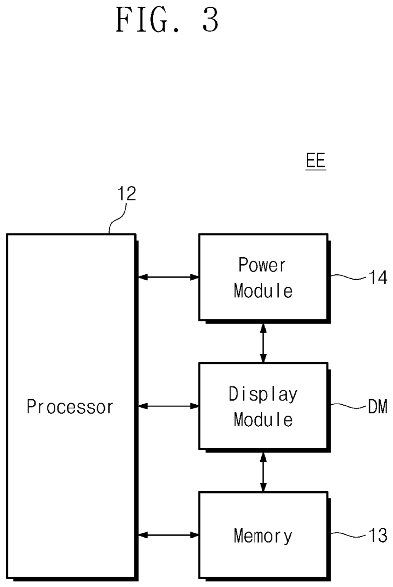

FIG. 3 is a block diagram of an electronic device EE according to embodiments of the present disclosure.

The electronic device EE according to one or more embodiments may include a display module DM, a processor 12, a memory 13, and a power module 14.

The processor 12 may include at least one of a central processing unit (CPU), an application processor (AP), a graphic processing unit (GPU), a communication processor (CP), an image signal processor (ISP), or a controller. The power module 14 may include a power supply module, such as a power adapter or a battery device, and a power conversion module that converts a power supplied by the power supply module to generate a power required for an operation of the electronic device EE.

The memory 13 may store data information suitable for an operation of the processor 12 or the display module DM. When the processor 12 executes an application stored in the memory 13, image data signals and/or input control signals are transmitted to the display module DM, and the display module DM may process the transmitted signals and output image information through a display screen.

At least one of components of the electronic device EE may be included in the display device DD (see FIG. 2) according to one or more embodiments. Additionally, some of the individual modules that are functionally included in one module among the components of the electronic device EE may be included in the display device DD (see FIG. 2), and other modules may also be provided separately from the display device DD (see FIG. 2). For example, the display device DD (see FIG. 2) includes the display module DM, and the processor 12, the memory 13, and the power module 14 may be provided in a form of other devices within the electronic device EE other than the display device DD (see FIG. 2).

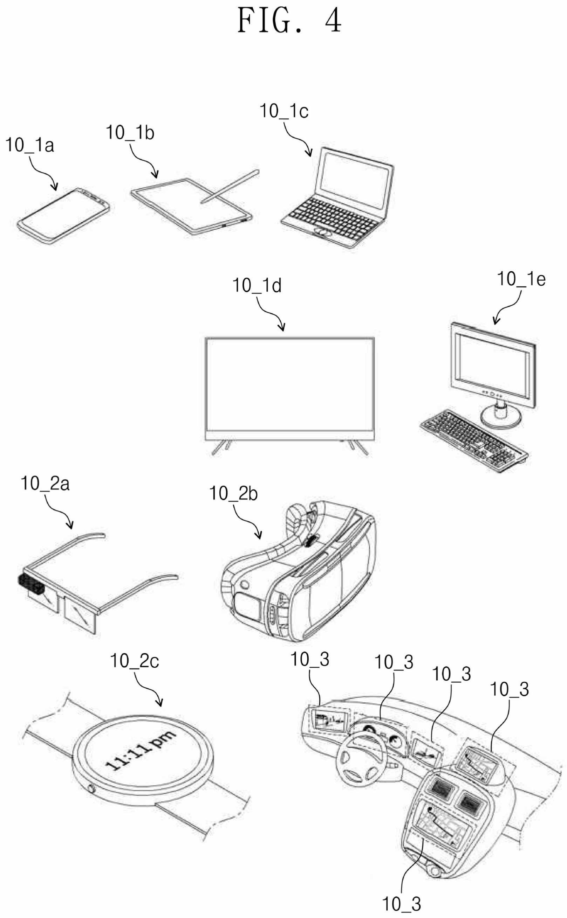

FIG. 4 is a view schematically illustrating electronic devices according to various embodiments. Referring to FIG. 4, the electronic device including the display device DD (see FIG. 2) according to one or more embodiments may include an electronic device for displaying images, such as a smart phone 10_1a, a tablet computer 10_1b, a laptop computer 10_1c, a television 10_1d, a desktop monitor 10_1e, and a wearable electronic device including the display module DM (see FIG. 3), such as smart glasses 10_2a, a head mounted display 10_2b, a smart watch 10_2c, as well as an automobile electronic device 10_3 including the display module DM (see FIG. 3), such as a center information display (CID) located on an instrument panel, a center fascia, or a dashboard of a car, and a room mirror display.

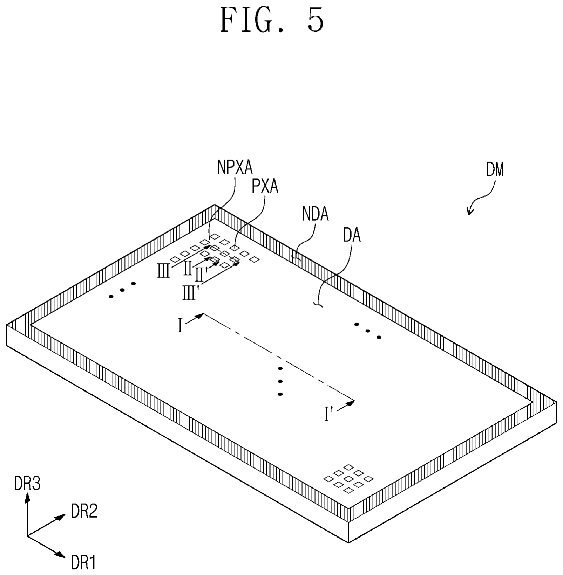

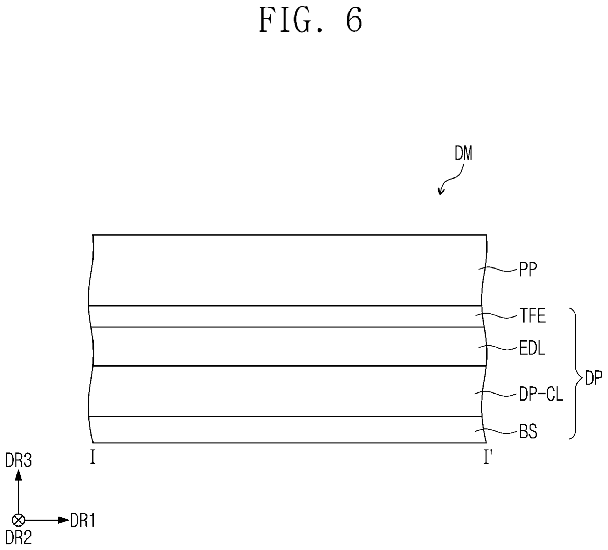

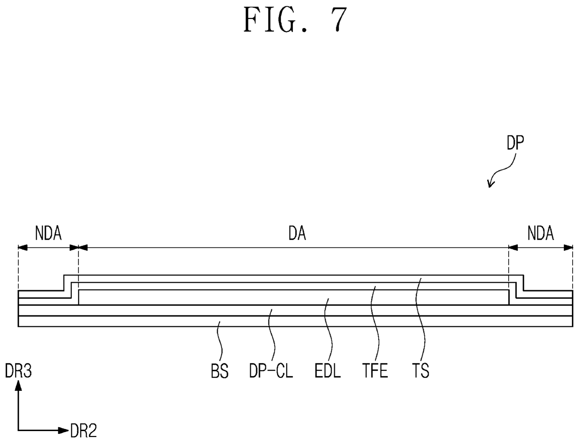

FIG. 5 is a perspective view of a display module according to one or more embodiments of the present disclosure. FIG. 6 is a cross-sectional view of a display module according to one or more embodiments of the present disclosure. FIG. 6 illustrates a cross section taken along the line I-I' of FIG. 5. FIG. 7 is a cross-sectional view of a display panel according to one or more embodiments of the present disclosure.

Referring to FIG. 5, a display module DM may include a display region DA and a non-display region NDA. The display region DA may include a plurality of light-emitting regions PXA and non-light-emitting regions NPXA. The light-emitting regions PXA may be referred to as pixel regions.

Referring to FIGS. 5 to 7, the display module DM may include a display panel DP and an optical layer PP located on the display panel DP. The display panel DP may include a display element layer EDL.

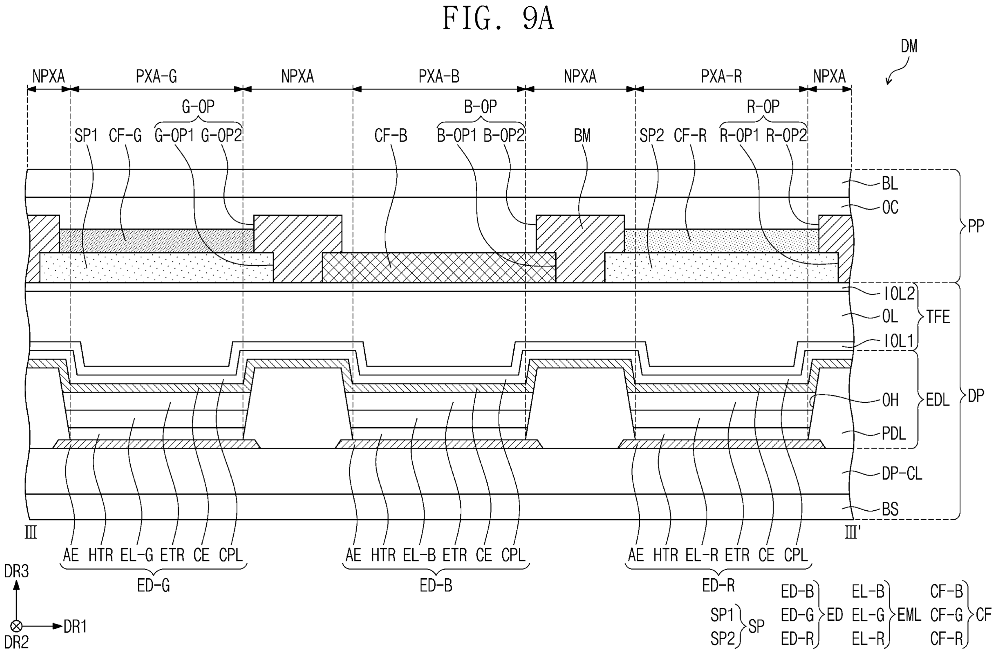

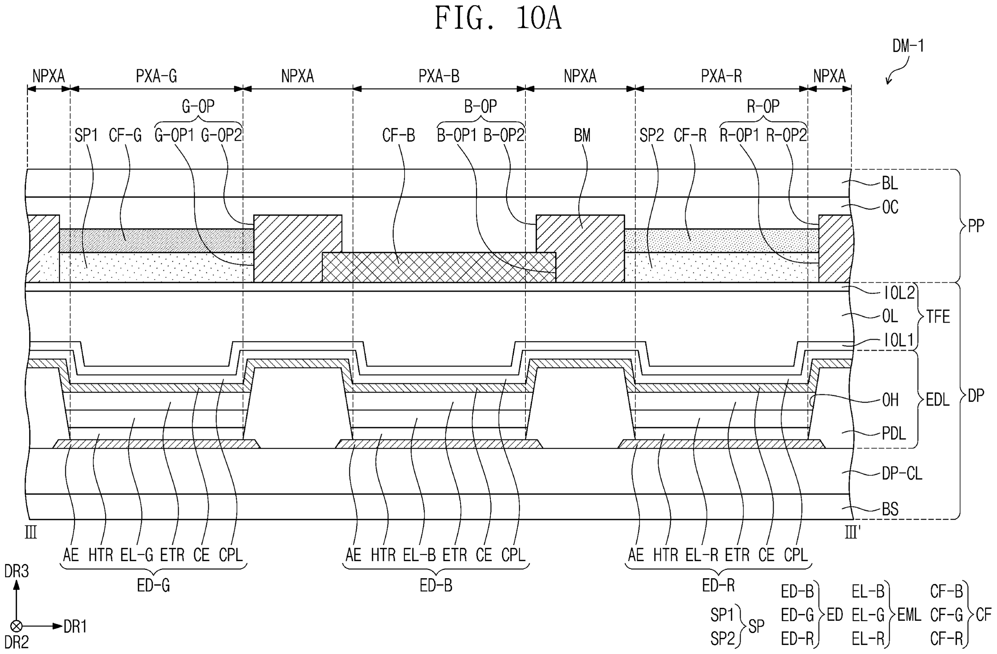

The display panel DP may include a base layer BS, a circuit layer DP-CL located on the base layer BS (as used herein, "located on" may mean "above"), and the display element layer EDL located on the circuit layer DP-CL. The display element layer EDL may include light-emitting elements ED-G, ED-B, and ED-R (see FIGS. 9A and 10A). Additionally, the display panel DP may include an encapsulation layer TFE located on the display element layer EDL. In one or more embodiments, the encapsulation layer TFE may be directly located on the display element layer EDL. However, the present disclosure is not limited thereto, and the encapsulation layer TFE may be bonded to the display element layer EDL via a separate member. Additionally, the display panel DP may also further include a touch sensor TS located on the encapsulation layer TFE.

The display panel DP may be configured to substantially generate an image. The display element layer EDL may include an organic light-emitting diode as a light-emitting element. In one or more embodiments of the present disclosure, the light-emitting element may also include a quantum dot light-emitting diode. That is, the light-emitting layer included in the light-emitting element may include an organic light-emitting material as a light-emitting material, or may include quantum dots as a light-emitting material. Alternatively, the display element layer EDL may also include an ultra-small light-emitting element as the light-emitting element. For example, the ultra-small light-emitting element may also include a micro-LED element and/or a nano-LED element, etc. The ultra-small light-emitting element has a micro or nano scale size, and may be a light-emitting element including an active layer located between a plurality of semiconductor layers.

Referring to FIG. 7, a display region DA and a non-display region NDA, which respectively correspond to the display region DA and the non-display region NDA illustrated in FIG. 5, may be defined in the display panel DP. The display region DA may be defined in the display panel DP as a region in which pixels are located. The non-display region NDA may be defined in the display panel DP as a region in which pixels are not located and in which signal lines for supporting pixel operations are located.

The optical layer PP is located on the display panel DP. The optical layer PP may be located on the display panel DP and control reflection of external light by the display panel DP.

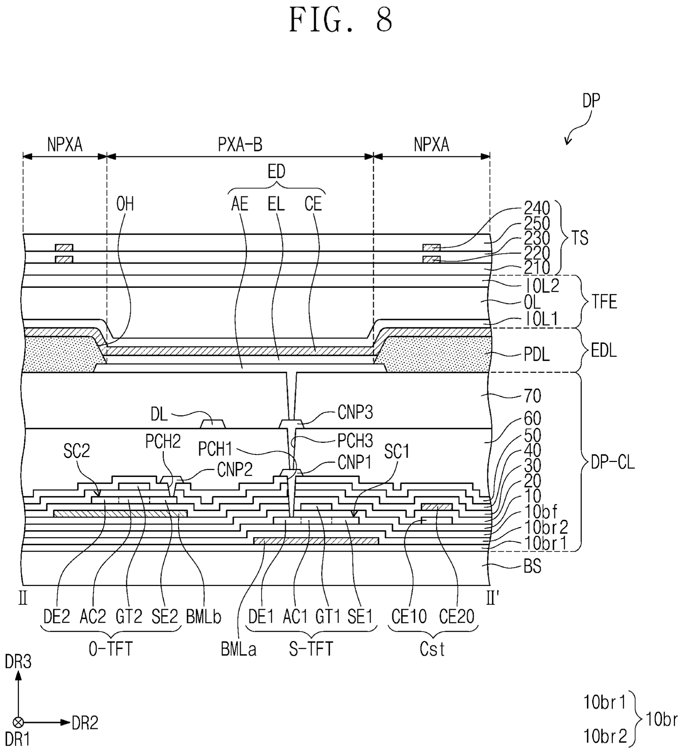

FIG. 8 is a cross-sectional view of a display panel DP according to one or more embodiments of the present disclosure. FIG. 8 is a cross-sectional view of a display module DM taken along the line II-II' of FIG. 5.

A pixel-driving circuit for driving a light-emitting element ED may include a plurality of pixel-driving elements. The pixel-driving circuit may include a plurality of transistors S-TFT and O-TFT and a capacitor Cst. FIG. 8 illustrates a silicon transistor S-TFT and an oxide transistor O-TFT as a transistor. The pixel-driving circuit of FIG. 8 is merely presented as one or more embodiments, and components of the pixel-driving circuit are not necessarily limited thereto. The pixel-driving circuit may also include only one transistor among the silicon transistor S-TFT and the oxide transistor O-TFT.

Referring to FIG. 8, a base layer BS is illustrated as a single layer. The base layer BS may include a synthetic resin, such as polyimide. The base layer BS may be formed by coating a synthetic resin layer on a work substrate (or a carrier substrate). The display module DM is completed by performing subsequent processes, and then the work substrate may be removed. In one or more embodiments of the present disclosure, the base layer BS may also have a multi-layered structure of a first synthetic resin layer, at least one inorganic layer, and a second synthetic resin layer.

Referring to FIG. 8, a barrier layer 10br may be located on the base layer BS. The barrier layer 10br reduces or prevents introduction of foreign substances from the outside. The barrier layer 10br may include at least one inorganic layer. The barrier layer 10br may include a silicon oxide layer and a silicon nitride layer. The silicon oxide layer and the silicon nitride layer may each be provided in plurality, and the silicon oxide layers and the silicon nitride layers may be alternately stacked.

The barrier layer 10br may include a lower barrier layer 10br1 and an upper barrier layer 10br2. A first shielding electrode BMLa may be located between the lower barrier layer 10br1 and the upper barrier layer 10br2. The first shielding electrode BMLa may correspond to the silicon transistor S-TFT. The first shielding electrode BMLa may include metal, such as molybdenum.

The first shielding electrode BMLa may receive a bias voltage. The first shielding electrode BMLa may also receive a first power voltage. The first shielding electrode BMLa may block an electric potential due to a polarization from affecting the silicon transistor S-TFT. The first shielding electrode BMLa may block external light from reaching the silicon transistor S-TFT. In one or more embodiments of the present disclosure, the first shielding electrode BMLa may also be a floating electrode isolated from other electrodes or wirings.

A buffer layer 10bf may be located on the barrier layer 10br. The buffer layer 10bf may reduce or prevent diffusion of metal atoms or impurities from the base layer BS into a first semiconductor pattern SC1 located above the buffer layer 10bf. The buffer layer 10bf may include at least one inorganic layer. The buffer layer 10bf may include a silicon oxide layer and a silicon nitride layer.

The first semiconductor pattern SC1 may be located on the buffer layer 10bf. The first semiconductor pattern SC1 may include a silicon semiconductor. For example, the silicon semiconductor may include amorphous silicon, polycrystalline silicon, etc. For example, the first semiconductor pattern SC1 may include low-temperature polysilicon.

The electrical properties of the first semiconductor pattern SC1 may vary depending on whether to be doped or not. The first semiconductor pattern SC1 may include a first region having high conductivity and a second region having low conductivity. The first region may be doped with an N-type dopant or a P-type dopant. The second region may be a non-doped region or a region doped at a concentration lower than that of the first region. A source region SE1, a channel region AC1 (or an active region), and a drain region DE1 of the silicon transistor S-TFT may be formed from the first semiconductor pattern SC1. The source region SE1 and the drain region DE1 may extend, on a cross section, from the channel region AC1 in directions opposite to each other.

A first insulating layer 10 may be located on the buffer layer 10bf. The first insulating layer 10 may cover the first semiconductor pattern SC1. The first insulating layer 10 may be an inorganic layer. The first insulating layer 10 may be a single-layered silicon oxide layer. An inorganic layer of a circuit layer DP-CL to be described later, as well as the first insulating layer 10, may have a single-layered or multi-layered structure, and may include at least one of the above-described materials, but is not limited thereto.

A gate GT1 of the silicon transistor S-TFT is located on the first insulating layer 10. The gate GT1 may be a portion of a metal pattern. The gate GT1 overlaps with the channel region AC1. During a process of doping the first semiconductor pattern SC1, the gate GT1 may serve as a mask. A first electrode CE10 of a capacitor Cst is located on the first insulating layer 10. Unlike what is illustrated in FIG. 8, the first electrode CE10 may have an integral shape with the gate GT1.

A second insulating layer 20 may be located on the first insulating layer 10 and cover the gate GT1. In one or more embodiments of the present disclosure, an upper electrode overlapping the gate GT1 may also be further located on the second insulating layer 20. A second electrode CE20 overlapping the first electrode CE10 may be located on the second insulating layer 20. The upper electrode may also have an integral shape with the second electrode CE20 on a plane.

A second shielding electrode BMLb is located on the second insulating layer 20. The second shielding electrode BMLb may correspond to the oxide transistor O-TFT. In one or more embodiments of the present disclosure, the second shielding electrode BMLb may also be omitted. According to one or more embodiments of the present disclosure, the first shielding electrode BMLa extends to a lower part of the oxide transistor O-TFT, and may also replace the second shielding electrode BMLb.

A third insulating layer 30 may be located on the second insulating layer 20. A second semiconductor pattern SC2 may be located on the third insulating layer 30. The second semiconductor pattern SC2 may include a channel region AC2 of the oxide transistor O-TFT. The second semiconductor pattern SC2 may include a metal oxide semiconductor. The second semiconductor pattern SC2 may include a transparent conductive oxide (TCO), such as indium tin oxide (ITO), indium zinc oxide (IZO), indium gallium zinc oxide (IGZO), zinc oxide (ZnOₓ), or indium oxide (In₂O₃).

The metal oxide semiconductor may include a plurality of regions SE2, AC2, and DE2 that are distinguished from each other according to whether the transparent conductive oxide is reduced. The region in which the transparent conductive oxide is reduced (hereinafter, referred to as a reduced region) has a higher conductivity than the region in which the transparent conductive oxide is not reduced (hereinafter, referred to as a non-reduced region). The reduced region substantially serves as a source/drain of a transistor or a signal line. The non-reduced region substantially corresponds to a semiconductor region (or a channel region) of a transistor. A fourth insulating layer 40 may be located on the third insulating layer 30. As illustrated in FIG. 8, the fourth insulating layer 40 may cover the second semiconductor pattern SC2. In one or more embodiments of the present disclosure, the fourth insulating layer 40 may also be an insulating pattern that overlaps a gate GT2 of the oxide transistor O-TFT and exposes a source region SE2 and a drain region DE2 of the oxide transistor O-TFT.

The gate GT2 of the oxide transistor O-TFT is located on the fourth insulating layer 40. The gate GT2 of the oxide transistor O-TFT may be a portion of the metal pattern. The gate GT2 of the oxide transistor O-TFT overlaps the channel region AC2. A fifth insulating layer 50 is located on the fourth insulating layer 40, and may cover the gate GT2. The first insulating layer 10 to the fifth insulating layer 50 may each be an inorganic layer.

A first connection pattern CNP1 and a second connection pattern CNP2 may be located on the fifth insulating layer 50. The first connection pattern CNP1 and the second connection pattern CNP2 may be formed through the same process so as to have the same material and the same stacked structure. The first connection pattern CNP1 may be connected to the drain region DE1 of the silicon transistor S-TFT via a first pixel contact hole PCH1 that passes through the first to fifth insulating layers 10, 20, 30, 40, and 50. The second connection pattern CNP2 may be connected to the source region SE2 of the oxide transistor O-TFT via a second pixel contact hole PCH2 that passes through the fourth and fifth insulating layers 40 and 50. The connection relation between the first connection pattern CNP1 and the second connection pattern CNP2 for the silicon transistor S-TFT and the oxide transistor O-TFT is not necessarily limited thereto.

A sixth insulating layer 60 may be located on the fifth insulating layer 50. A third connection pattern CNP3 may be located on the sixth insulating layer 60. The third connection pattern CNP3 may be connected to the first connection pattern CNP1 via a third pixel contact hole PCH3 that passes through the sixth insulating layer 60. A data line DL may be located on the sixth insulating layer 60. A seventh insulating layer 70 may be located on the sixth insulating layer 60 and cover the third connection pattern CNP3 and the data line DL. The third connection pattern CNP3 and the data line DL may be formed through the same process so as to have the same material and the same stacked structure. The sixth insulating layer 60 and the seventh insulating layer 70 may each be an organic layer.

A light-emitting element ED may include an anode AE (or a first electrode), a functional layer EL, and a cathode CE (or a second electrode). The anode AE of the light-emitting element ED may be located on the seventh insulating layer 70. The anode AE may be a transflective electrode, or a reflective electrode. Positions of the anode AE and the cathode CE may be interchanged.

A pixel-defining film PDL may be located on the seventh insulating layer 70. The pixel-defining film PDL may be an organic layer. The pixel-defining film PDL may have a light-absorbing property, and for example, may have a black color. The pixel-defining film PDL may include a black coloring agent. The black coloring agent may include a black dye and a black pigment. The black coloring agent may include carbon black, metal, such as chromium, or an oxide thereof. The pixel-defining film PDL may correspond to a light-blocking pattern that has a light-blocking property.

The pixel-defining film PDL may cover a portion of the anode AE. For example, a pixel opening OH, which exposes a portion of the anode AE may be defined in the pixel-defining film PDL. A light-emitting region PXA may be defined to correspond to the pixel opening OH. FIG. 8 illustrates one light-emitting region PXA-B corresponding to a first light-emitting region PXA-B. The cross sections corresponding to a second light-emitting region PXA-G and a third light-emitting region PXA-R of FIGS. 9A and 10A may also be substantially the same as that of FIG. 8. However, a light-emitting layer including a material different from that of the first light-emitting region PXA-B may be located in the second light-emitting region PXA-G and the third light-emitting region PXA-R.

In one or more embodiments of the present disclosure, a functional layer EL may include a hole transport region HTR (see FIGS. 9A and 10A), a light-emitting layer EML (see FIGS. 9A and 10A), and an electron transport region ETR (see FIGS. 9A and 10A). The hole transport region HTR (see FIGS. 9A and 10A) and the electron transport region ETR (see FIGS. 9A and 10A) may each include a plurality of sub-functional layers. For example, the hole transport region HTR (see FIGS. 9A and 10A) may include a hole injection layer and a hole transport layer as the sub-functional layers, and the electron transport region ETR (see FIGS. 9A and 10A) may include an electron injection layer and an electron transport layer as the sub-functional layers. One or more embodiments of the present disclosure is not limited thereto, and the hole transport region HTR (see FIGS. 9A and 10A) may further include an electron-blocking layer, a hole buffer layer or the like as the sub-functional layer, and the electron transport region ETR (see FIGS. 9A and 10A) may further include a hole-blocking layer, an electron buffer layer, or the like as the sub-functional layer.

An encapsulation layer TFE may cover a light-emitting element ED. The encapsulation layer TFE may include a first inorganic encapsulation layer IOL1, an organic encapsulation layer OL, and a second inorganic encapsulation layer IOL2, which are sequentially stacked, but layers constituting the encapsulation layer TFE are not necessarily limited thereto. The inorganic encapsulation layers IOL1 and IOL2 may include a silicon nitride layer, a silicon oxynitride layer, a silicon oxide layer, a titanium oxide layer, an aluminum oxide layer or the like. The inorganic encapsulation layers IOL1 and IOL2 may also each have a multi-layered structure. The organic encapsulation layer OL may include an acrylate-based organic layer, but is not limited thereto.

A touch sensor TS includes a plurality of conductive patterns. The touch sensor TS may include at least one conductive layer (or at least one sensor conductive layer) including a plurality of conductive patterns, and at least one insulating layer (or at least one sensor insulating layer). The touch sensor TS may include a first insulating layer 210 (or a first sensor insulating layer), a first conductive layer 220 (or a first sensor conductive layer), a second insulating layer 230 (or a second sensor insulating layer), a second conductive layer 240 (or a second sensor conductive layer), and a third insulating layer 250 (or a third sensor insulating layer). FIG. 8 briefly illustrates a plurality of conductive patterns included in each of the first conductive layer 220 and the second conductive layer 240.

The first insulating layer 210 may be directly located on the encapsulation layer TFE. The first insulating layer 210 may be an inorganic layer including at least one of silicon nitride, silicon oxynitride, or silicon oxide. The first conductive layer 220 and the second conductive layer 240 may each have a single-layered structure or a multi-layered structure in which layers are stacked in the third direction DR3. The first conductive layer 220 and the second conductive layer 240 may include conductive lines defining mesh-shaped electrodes. The conductive line of the first conductive layer 220 and the conductive line of the second conductive layer 240 may or may not be connected to each other via a contact hole that passes through the second insulating layer 230 according to positions of the conductive lines.

The first conductive layer 220 and the second conductive layer 240 having a single-layered structure may include a metal layer or a transparent conductive layer. The metal layer may include molybdenum, silver, titanium, copper, aluminum, or an alloy thereof. The transparent conductive layer may include a transparent conductive oxide, such as indium tin oxide (ITO), indium zinc oxide (IZO), zinc oxide (ZnOₓ), or indium zinc tin oxide (IZTO). Additionally, the transparent conductive layer may include a conductive polymer, such as PEDOT, metal nanowire, graphene, etc.

The first conductive layer 220 and the second conductive layer 240 having a multi-layered structure may include metal layers. The metal layers may have, for example, a three-layered structure of titanium/aluminum/titanium. The conductive layer having the multi-layered structure may include at least one metal layer and at least one transparent conductive layer. The second insulating layer 230 may be located between the first conductive layer 220 and the second conductive layer 240. In this specification, the second insulating layer 230, which is located between the first conductive layer 220 and the second conductive layer 240, may be described as a "sensing-insulating layer." The third insulating layer 250 may cover the second conductive layer 240. In one or more embodiments of the present disclosure, the third insulating layer 250 may be omitted. The second insulating layer 230 and the third insulating layer 250 may include an inorganic layer or an organic layer.

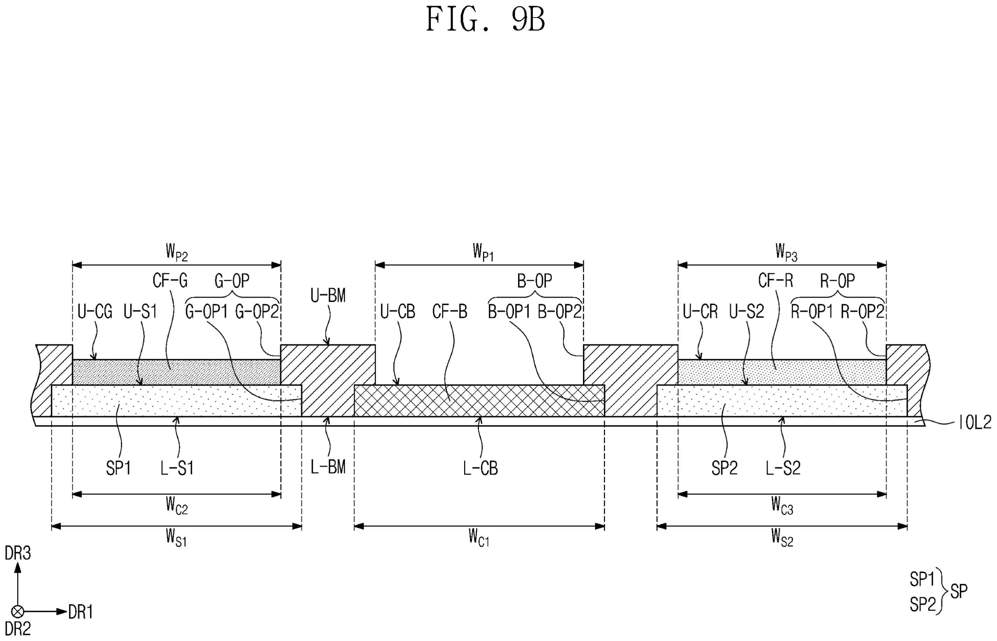

FIG. 9A is an enlarged cross-sectional view illustrating a partial region of a display module according to one or more embodiments of the present disclosure. FIG. 9B is an enlarged cross-sectional view illustrating a portion of some components of the display module according to one or more embodiments of the present disclosure. FIG. 9A illustrates a cross section taken along the line III-III' of FIG. 5. FIG. 9B illustrates a cross section taken along the line III-III' of FIG. 5, focusing on the components included in an optical layer PP of the display module according to one or more embodiments.

Referring to FIG. 9A, a display module DM according to one or more embodiments may include a display panel DP and the optical layer PP located on the display panel DP. The display panel DP may include a base layer BS, a circuit layer DP-CL located on the base layer BS, and a display element layer EDL located on the circuit layer DP-CL.

Referring to FIGS. 5 and 9A, a plurality of light-emitting regions PXA may be located in the display region DA of the display module DM according to one or more embodiments. The plurality of light-emitting regions PXA may each be a region that emits light generated from each of light-emitting elements ED-G, ED-B, and ED-R.

The light-emitting regions PXA of the display module DM according to one or more embodiments may be arranged in a stripe form. Referring to FIG. 5, etc., the plurality of light-emitting regions PXA may be aligned along the first direction DR1 or the second direction DR2. However, the present disclosure is not limited thereto, and the light-emitting regions PXA may be arranged in a PENTILE^{™} form or a Diamond Pixel^{™} form (PENTILE^{™} and Diamond Pixel^{™} being registered trademarks of Samsung Display Co., Ltd., Republic of Korea).

Additionally, in FIG. 5, etc., all the light-emitting regions PXA are illustrated as having similar areas. However, the present disclosure is not limited thereto, and the light-emitting regions PXA may have different areas according to wavelength ranges of emitted light.

The light-emitting regions PXA may include first to third light-emitting regions PXA-B, PXA-G, and PXA-R. The display module DM may include a plurality of light-emitting regions PXA-B, PXA-G, and PXA-R repeatedly located in the entire display region DA. The display module DM according to one or more embodiments may include the first to third light-emitting regions PXA-B, PXA-G, and PXA-R that are separated from each other. Additionally, the display module DM may include a non-light-emitting region NPXA located around the first to third light-emitting regions PXA-B, PXA-G, and PXA-R. The non-light-emitting region NPXA defines boundaries between the first to third light-emitting regions PXA-B, PXA-G, and PXA-R. The non-light-emitting region NPXA may surround the first to third light-emitting regions PXA-B, PXA-G, and PXA-R. A structure, such as a pixel-defining film PDL, which reduces or prevents color-mixing between the first to third light-emitting regions PXA-B, PXA-G, and PXA-R may be located in the non-light-emitting region NPXA.

The first to third light-emitting regions PXA-B, PXA-G, and PXA-R may each be a region defined by the pixel-defining film PDL. The non-light-emitting region NPXA may be a region corresponding to the pixel-defining film PDL between the adjacent first to third light-emitting regions PXA-B, PXA-G, and PXA-R.

The first to third light-emitting regions PXA-B, PXA-G, and PXA-R may each be a region in which light generated from each of first to third light-emitting elements ED-B, ED-G, and ED-R is emitted. The first to third light-emitting regions PXA-B, PXA-G, and PXA-R may be spaced apart from each other on a plane.

In this specification, the first to third light-emitting regions PXA-B, PXA-G, and PXA-R may each correspond to a pixel. The pixel-defining film PDL may define the first to third light-emitting elements ED-B, ED-G, and ED-R. Light-emitting layers EL-B, EL-G, and EL-R of the first to third light-emitting elements ED-B, ED-G, and ED-R may each be located in an opening OH defined by the pixel-defining film PDL to be separated from each other.

The pixel-defining film PDL may be formed of a polymer resin. For example, the pixel-defining film PDL may be formed of a polyacrylate-based resin or a polyimide-based resin. Additionally, the pixel-defining film PDL may be further formed of an inorganic material in addition to a polymer resin. The pixel-defining film PDL may be formed of a light-absorbing material, or may be formed of a black pigment or a black dye. The pixel-defining film PDL formed of a black pigment or a black dye may implement a black pixel-defining film. When forming the pixel-defining film PDL, carbon black, etc., may be used as a black pigment or a black dye, but the present disclosure is not limited thereto.

Additionally, the pixel-defining film PDL may be formed of an inorganic material. For example, the pixel-defining film PDL may be formed of an inorganic material, such as silicon nitride (SiNₓ), silicon oxide (SiOₓ), and silicon oxynitride (SiOₓN_{y}).

The first to third light-emitting regions PXA-B, PXA-G, and PXA-R may be distinguished according to colors of light generated from the first to third light-emitting elements ED-B, ED-G, and ED-R. FIG. 9A illustrates the display module DM according to one or more embodiments in which three light-emitting regions PXA-B, PXA-G, and PXA-R respectively emit blue light, green light, and red light. For example, in the display module DM according to one or more embodiments, the first light-emitting region PXA-B may correspond to a blue light-emitting region, the second light-emitting region PXA-G may correspond to a green light-emitting region, and the third light-emitting region PXA-R may correspond to a red light-emitting region. In one or more embodiments, the first light-emitting region PXA-B may emit light having a light-emitting wavelength of about 410 nm to about 480 nm, the second light-emitting region PXA-G may emit light having a light-emitting wavelength of about 520 nm to about 600 nm, and the third light-emitting region PXA-R may emit light having a light-emitting wavelength of about 620 nm to about 700 nm.

In the display module DM according to one or more embodiments, the light-emitting elements ED-B, ED-G, and ED-R may emit light having different respective wavelength ranges. For example, in the display module DM according to one or more embodiments, the first light-emitting element ED-B may correspond to a blue light-emitting element that emits blue light, the second light-emitting element ED-G may correspond to a green light-emitting element that emits green light, and the third light-emitting element ED-R may correspond to a red light-emitting element that emits red light. That is, the blue light-emitting region PXA-B, the green light-emitting region PXA-G, and the red light-emitting region PXA-R of the display module DM may respectively correspond to the first light-emitting element ED-B, the second light-emitting element ED-G, and the third light-emitting element ED-R. However, the present disclosure is not limited thereto, and the first to third light-emitting elements ED-B, ED-G, and ED-R may emit light having the same wavelength range, or at least one thereamong may emit light having a wavelength range different from the others.

FIG. 9A, etc., illustrate three light-emitting regions PXA-B, PXA-G, and PXA-R that are separated from each other, but the present disclosure is not limited thereto, and the display module DM according to one or more embodiments may also include four or more light-emitting regions having different light-emitting properties or only two.

The base layer BS of the display panel DP may be a member that provides a base surface on which the display element layer EDL is located (or stacked). The base layer BS may be a glass substrate, a metal substrate, a plastic substrate, etc. However, the present disclosure is not limited thereto, and the base layer BS may be an inorganic layer, an organic layer, or a composite material layer.

In one or more embodiments, the circuit layer DP-CL is located on the base layer BS, and may include a plurality of transistors. In one or more embodiments, the transistors may each include a control electrode, an input electrode, and an output electrode. For example, the circuit layer DP-CL may include a switching transistor or a driving transistor for driving the light-emitting elements ED-B, ED-G, and ED-R of the display element layer EDL.

The plurality of light-emitting elements ED-B, ED-G, and ED-R according to one or more embodiments may each include a first electrode AE, a second electrode CE facing the first electrode AE, and a respective one of the light-emitting layers EL-B, EL-G, and EL-R located between the first electrode AE and the second electrode CE. A hole transport region HTR may be located between the first electrode AE and a corresponding one of the light-emitting layers EL-B, EL-G, and EL-R. An electron transport region ETR may be located between the second electrode CE and the light-emitting layers EL-B, EL-G, and EL-R. In one or more embodiments, the plurality of light-emitting elements ED-R, ED-G, and ED-B may emit light in a direction from the first electrode AE to the second electrode CE. That is, the light-emitting elements ED-B, ED-G, and ED-R according to one or more embodiments may have a normal structure in which the hole transport region HTR is located under the light-emitting layers EL-B, EL-G, and EL-R, and the electron transport region ETR is located on the light-emitting layers EL-B, EL-G, and EL-R in the direction to which light is emitted. However, the present disclosure is not limited thereto, and the light-emitting elements ED-B, ED-G, and ED-R according to one or more embodiments may also have an inverted element structure in which the electron transport region ETR is located under the light-emitting layers EL-B, EL-G, and EL-R, and the hole transport region HTR is located on the light-emitting layers EL-B, EL-G, and EL-R in the direction to which light is emitted.

In the light-emitting element ED according to one or more embodiments, the first electrode AE has a conductivity. The first electrode AE may be formed of a metal alloy or a conductive compound. The first electrode AE may be an anode. The first electrode AE may be a pixel electrode.

In the light-emitting element ED according to one or more embodiments, the first electrode AE may be a reflective electrode. However, the present disclosure is not limited thereto. For example, the first electrode AE may be a transmissive, transflective electrode, or the like. When the first electrode AE is the transflective electrode or the reflective electrode, the first electrode AE may include Ag, Mg, Cu, Al, Pt, Pd, Au, Ni, Nd, Ir, Cr, Li, Ca, LiF/Ca, LiF/Al, Mo, Ti, or a compound or mixture thereof (for example, a mixture of Ag and Mg). Alternatively, the first electrode AE may have a multi-layered structure including a reflective film or a transflective film formed of the above-described materials, and a transparent conductive film formed of indium tin oxide (ITO), indium zinc oxide (IZO), zinc oxide (ZnO), indium tin zinc oxide (ITZO), or the like. For example, the first electrode AE may be a multi-layered metal film, and may have a structure in which metal films of ITO/Ag/ITO are stacked.

The hole transport region HTR is provided on the first electrode AE. The hole transport region HTR may include a hole injection layer, a hole transport layer, etc. Additionally, the hole transport region HTR may further include at least one of a hole buffer layer or an electron-blocking layer in addition to the hole injection layer and the hole transport layer. The hole buffer layer may compensate a resonance distance according to a wavelength of light emitted from a light-emitting layer to improve light emission efficiency. A material capable of being included in the hole transport region HTR may be used as a material to be included in the hole buffer layer. The electron-blocking layer is a layer that functions as reducing or preventing injection of electrons from the electron transport region ETR to the hole transport region HTR.

The hole transport region HTR may have a single layer formed of a single material, a single layer formed of a plurality of different materials, or may have a multi-layered structure of a plurality of layers that are formed of a plurality of different materials. For example, the hole transport region HTR may have a single-layered structure formed of a plurality of different materials, or may have a structure, such as a hole injection layer/a hole transport layer, a hole injection layer/a hole transport layer/a hole buffer layer, a hole injection layer/a hole buffer layer, a hole transport layer/a hole buffer layer or a hole injection layer/a hole transport layer/an electron-blocking layer, which are sequentially stacked from the first electrode AE, but the present disclosure is not limited thereto.

The hole transport region HTR may include a hole injection material or a hole transport material. For example, the hole transport region HTR may include the hole injection layer and the hole transport layer, and the hole injection material and the hole transport material may respectively be used for the hole injection layer and the hole transport layer.

The light-emitting layers EL-B, EL-G, and EL-R may be located on the hole transport region HTR. The light-emitting layers EL-B, EL-G, and EL-R may have a single layer formed of a single material, a single layer formed of a plurality of different materials, or may have a multi-layered structure of a plurality of layers that are formed of a plurality of different materials. The material constituting the light-emitting layers EL-B, EL-G, and EL-R is not particularly limited as long as the material is typically used. For example, the light-emitting layers EL-B, EL-G, and EL-R may include materials that emit red light, green light, and blue light, and may include a fluorescent material or a phosphorescent material. The light-emitting layers EL-B, EL-G, and EL-R of the light-emitting elements ED-B, ED-G, and ED-R according to one or more embodiments may include an organic light-emitting material, a metal organic complex, quantum dots or the like as a light-emitting material. FIG. 9A illustrates the light-emitting elements ED-B, ED-G, and ED-R including respectively one light-emitting layer among the light-emitting layers EL-B, EL-G, and EL-R, but in one or more embodiments, the light-emitting elements ED-B, ED-G, and ED-R may include a plurality of light-emitting stacks, each of which includes at least one light-emitting layer.

In the light-emitting element ED according to one or more embodiments, the electron transport region ETR is provided on each of the light-emitting layers EL-B, EL-G, and EL-R. The electron transport region ETR may include at least one of a hole-blocking layer, an electron transport layer, or an electron injection layer, but the present disclosure is not limited thereto.

The electron transport region ETR may have a single layer formed of a single material, a single layer formed of a plurality of different materials, or may have a multi-layered structure of a plurality of layers that are formed of a plurality of different materials.

For example, the electron transport region ETR may have not only a single-layered structure of an electron injection layer or an electron transport layer, but also a single-layered structure formed of an electron injection material and an electron transport material. Additionally, the electron transport region ETR may have a single-layered structure formed of a plurality of different materials, or may have a structure of the electron transport layer/the electron injection layer, the hole-blocking layer/the electron transport layer/the electron injection layer that are sequentially stacked from the light-emitting layers EL-B, EL-G, and EL-R, but the present disclosure is not limited thereto.

The electron transport region ETR may include an electron injection material or an electron transport material. For example, when the electron transport region ETR includes the electron injection layer and the electron transport layer, the electron injection material and the electron transport material may be respectively used for the electron injection layer and the electron transport layer.

The second electrode CE is provided on the electron transport region ETR. The second electrode CE may be a common electrode or negative electrode. The second electrode CE may be a transmissive electrode, a transflective electrode, or a reflective electrode. When the second electrode CE is a transmissive electrode, the second electrode CE may be formed of a transparent metal oxide, such as indium tin oxide (ITO), indium zinc oxide (IZO), zinc oxide (ZnO), indium tin zinc oxide (ITZO), etc.

When the second electrode CE is a transflective electrode or a reflective electrode, the second electrode CE may include Ag, Mg, Cu, Al, Pt, Pd, Au, Ni, Nd, Ir, Cr, Li, Ca, LiF/Ca, LiF/Al, Mo, Ti, Yb, or a compound including the same (for example, AgYb, AgMg, and/or MgAg compounds according to a content, etc.), or a mixture thereof (for example, a mixture of Ag and Mg). Alternatively, the second electrode CE may have a multi-layered structure of a reflective film or a transflective film that is formed of the above-described materials, and a transparent conductive film formed of indium tin oxide (ITO), indium zinc oxide (IZO), zinc oxide (ZnO), indium tin zinc oxide (ITZO), or the like.

In one or more embodiments, the second electrode CE may be connected to an auxiliary electrode. When the second electrode CE is connected to the auxiliary electrode, resistance of the second electrode CE may be reduced.

In one or more embodiments illustrated in FIG. 9A, the hole transport region HTR, the light-emitting layers EL-B, EL-G, and EL-R, and the electron transport region ETR of the respective first to third light-emitting elements ED-B, ED-G, and ED-R are each located within a pixel opening OH, and may be separated from the hole transport region HTR, the light-emitting layers EL-B, EL-G, and EL-R, and the electron transport region ETR of adjacent light-emitting regions. That is, in one or more embodiments, the hole transport region HTR, the light-emitting layers EL-R, EL-G, and EL-B, and the electron transport region ETR may be patterned and located within each of the pixel openings OH. However, the present disclosure is not limited thereto, and the hole transport region HTR, the light-emitting layers EL-R, EL-G, and EL-B, and the electron transport region ETR may also be located in the first to third light-emitting regions PXA-B, PXA-G, and PXA-R in common. Unlike what is illustrated in FIG. 9A, the hole transport region HTR, the light-emitting layers EL-R, EL-G, and EL-B, and the electron transport region ETR, which overlap the first to third light-emitting regions PXA-B, PXA-G, and PXA-R, may each have an integral shape.

In one or more embodiments, the light-emitting element ED may further include a capping layer CPL located on the second electrode CE. The capping layer CPL may include a multi-layer or a single layer.

In one or more embodiments, the capping layer CPL may be an organic layer or an inorganic layer. For example, when the capping layer CPL includes an inorganic material, the inorganic material may include an alkali metal compound, such as LiF, an alkali earth-metal compound, such as MgF₂, SiON, SiNₓ, or SiO_{y}.

For example, when the capping layer CPL includes an organic material, the organic material may include α-NPD, NPB, TPD, m-MTDATA, Alq₃, CuPc, N4,N4,N4',N4'-tetra(biphenyl-4-yl)biphenyl-4,4'-diamine (TPD15), 4,4',4"-Tris(carbazol sol-9-yl)triphenylamine (TCTA), etc., or may include an epoxy resin or acrylate, such as methacrylate. However, the present disclosure is not limited thereto.

The capping layer CPL may have a refractive index of about 1.6 or more. For example, the capping layer CPL may have a refractive index of about 1.6 or more with respect to the light in a wavelength range of about 550 nm to about 660 nm.

An encapsulation layer TFE may be located on the display element layer EDL. The encapsulation layer TFE may be located on the light-emitting elements ED-B, ED-G, and ED-R. The encapsulation layer TFE may seal the light-emitting elements ED-B, ED-G, and ED-R. The encapsulation layer TFE may be provided as a common layer in the entire of the first to third light-emitting regions PXA-B, PXA-G, and PXA-R. That is, the encapsulation layer TFE may be provided as a common layer to overlap the first to third light-emitting regions PXA-B, PXA-G, and PXA-R, and the non-light-emitting region NPXA.

The encapsulation layer TFE may be located on the second electrode CE. The encapsulation layer TFE may be directly located on the second electrode CE. Additionally, when the display element layer EDL according to one or more embodiments further includes the capping layer CPL, the encapsulation layer TFE may be directly located on the capping layer CPL. The encapsulation layer TFE may cover the light-emitting elements ED-B, ED-G, and ED-R. The encapsulation layer TFE may seal the display element layer EDL. The encapsulation layer TFE may be a thin-film encapsulation layer.

The encapsulation layer TFE may have a stacked structure of a plurality of layers. The encapsulation layer TFE according to one or more embodiments may include at least one organic layer (hereinafter, an organic encapsulation layer) and at least one inorganic layer (hereinafter, an inorganic encapsulation layer). The encapsulation layer TFE may include a first inorganic encapsulation layer IOL1, an organic encapsulation layer OL, and a second inorganic encapsulation layer IOL2. The first inorganic encapsulation layer IOL1, the organic encapsulation layer OL, and the second inorganic encapsulation layer IOL2 may be sequentially located along the third direction DR3.

The first inorganic encapsulation layer IOL1 may be located on the second electrode CE. The first inorganic encapsulation layer IOL1 may be directly located on the second electrode CE. As illustrated in FIG. 9A, when the display panel DP further includes the capping layer CPL, the first inorganic encapsulation layer IOL1 may be located on the capping layer CPL. The first inorganic encapsulation layer IOL1 may be directly located on the capping layer CPL. The first inorganic encapsulation layer IOL1 may have a substantially constant thickness on the light-emitting elements ED-B, ED-G, and ED-R, and the pixel-defining film PDL that defines the light-emitting elements ED-B, ED-G, and ED-R.

The first inorganic encapsulation layer IOL1 may function as protecting the display element layer EDL against moisture/oxygen. The first inorganic encapsulation layer IOL1 may include an inorganic material to have a high film density, and may have a relatively strong bonding force with a functional layer located below the first inorganic encapsulation layer IOL1. Accordingly, it may be possible to reduce or prevent infiltration of moisture or oxygen into an interface between the first inorganic encapsulation layer IOL1 and the functional layer located under the first inorganic encapsulation layer IOL1, such as the second electrode CE, and to reduce or prevent the likelihood of the first inorganic encapsulation layer IOL1 being peeled off. The first inorganic encapsulation layer IOL1 may include at least one of silicon nitride, silicon oxynitride, silicon oxide, titanium oxide, or aluminum oxide.

The organic encapsulation layer OL may be located on the first inorganic encapsulation layer IOL1. The organic encapsulation layer OL may be directly located on the first inorganic encapsulation layer IOL1. The organic encapsulation layer OL may function to protect the display element layer EDL against foreign substances, such as dust particles. The organic encapsulation layer OL may have a flat upper surface. The organic encapsulation layer OL may reduce a step of the first inorganic encapsulation layer IOL1. The organic encapsulation layer OL is provided so as to reduce a step of an upper surface of the first inorganic encapsulation layer IOL1, thereby making it possible for a functional layer to be uniformly located on the organic encapsulation layer OL.

The organic encapsulation layer OL may include an acrylate-based resin, a urethane-based resin, a fluorine-based resin, an epoxy-based resin, a polyester-based resin, a polyamide-based resin, a silicone-based resin, or a combination thereof.

The second inorganic encapsulation layer IOL2 may be located on the organic encapsulation layer OL. The second inorganic encapsulation layer IOL2 may be directly located on the organic encapsulation layer OL. In one or more embodiments, the second inorganic encapsulation layer IOL2 may define the uppermost surface of the encapsulation layer TFE.

The second inorganic encapsulation layer IOL2 may protect the display element layer EDL against moisture/oxygen. The second inorganic encapsulation layer IOL2 may have a substantially uniform thickness on the organic encapsulation layer OL, and may have a dense film density. Accordingly, the second inorganic encapsulation layer IOL2 may have a strong bonding force with the organic encapsulation layer OL, and thus may reduce or prevent infiltration of moisture or oxygen into an interface between the organic encapsulation layer OL and the second inorganic encapsulation layer IOL2. In one or more embodiments, the second inorganic encapsulation layer IOL2 may include at least one of silicon nitride, silicon oxynitride, silicon oxide, titanium oxide, or aluminum oxide.

In one or more embodiments, the encapsulation layer TFE may further include an additional organic encapsulation layer and an additional inorganic encapsulation layer located on the second inorganic encapsulation layer IOL2. The encapsulation layer TFE may further include n additional organic encapsulation layers (where n is a natural number of about 1 or more) and n additional inorganic encapsulation layers. The n additional organic encapsulation layers and the n additional inorganic encapsulation layers may be alternately located. On average, the n additional organic encapsulation layers may have thicknesses that is greater than those of the n additional inorganic encapsulation layers, but the present disclosure is not limited thereto. The contents described with reference to the organic encapsulation layer OL and the first and second inorganic encapsulation layers IOL1 and IOL2 may be similarly applied to materials of the additional organic encapsulation layer and the additional inorganic encapsulation layer.

An optical layer PP may be located on the display panel DP. The optical layer PP may be a reflection reduction layer that reduces reflectance for external light. The optical layer PP may include color filters that correspond to a pixel arrangement and an emission color of the display panel DP. The color filters may be arranged in consideration of emission colors of pixels included in the display panel DP.

In one or more embodiments, the optical layer PP may include a base substrate BL and a color filter CF.

The base substrate BL may serve as a member for providing a base surface on which the color filter CF, etc., are located. The base substrate BL may be a glass substrate, a metal substrate, a plastic substrate, etc. However, the present disclosure is not limited thereto, and the base substrate BL may be an inorganic layer, an organic layer, or a composite material layer.

The color filter CF may include a plurality of color filters CF-B, CF-G, and CF-R. The color filter CF may include first to third color filters CF-B, CF-G, and CF-R. The first to third color filters CF-B, CF-G, and CF-R may respectively correspond to the first to third light-emitting elements ED-B, ED-G, and ED-R (based on the light emitted from the light-emitting elements ED-B, ED-G, and ED-R). For example, the first color filter CF-B may be a blue color filter, the second color filter CF-G may be a green color filter, and the third color filter CF-R may be a red color filter. The first to third color filters CF-B, CF-G, and CF-R may respectively correspond to the first to third pixel regions PXA-B, PXA-G, and PXA-R.

The first to third color filters CF-B, CF-G, and CF-R may each include a pigment or a dye. The first color filter CF-B may include a blue pigment or a blue dye, the second color filter CF-G may include a green pigment or a green dye, and the third color filter CF-R may include a red pigment or a red dye. However, the present disclosure is not limited thereto, and the first color filter CF-B may not include a pigment or a dye. The first color filter CF-B may include a polymer photosensitive resin and may not include a pigment or a dye. The first color filter CF-B may be transparent. The first color filter CF-B may be formed of a transparent photosensitive resin.

The optical layer PP may include a light-blocking layer BM. The light-blocking layer BM may be located between the color filters CF-B, CF-G, and CF-R. The light-blocking layer BM may define boundaries between the adjacent color filters CF-B, CF-G, and CF-R. The light-blocking layer BM may correspond to the non-light-emitting region NPXA located between the light-emitting regions PXA-B, PXA-G, and PXA-R.

The light-blocking layer BM may function as reducing or preventing light leakage and color-mixing. The light-blocking layer BM may be formed as a blue filter, or formed of an organic light-blocking material or an inorganic light-blocking material that includes a black pigment or a black dye. The light-blocking layer BM may be a black matrix.

Openings B-OP, G-OP, and R-OP that respectively correspond to the light-emitting regions PXA-B, PXA-G, and PXA-R may be defined in the light-blocking layer BM. First to third openings B-OP, G-OP, and R-OP that respectively correspond to the first to third light-emitting regions PXA-B, PXA-G, and PXA-R may be defined in the light-blocking layer BM. On a plane, or in plan view, the first opening B-OP may (e. g. only) overlap the first light-emitting region PXA-B, the second opening G-OP may (e. g. only) overlap the second light-emitting region PXA-G, and the third opening R-OP may (e. g. only) overlap the third light-emitting region PXA-R.

The color filters CF-B, CF-G, and CF-R may be respectively located within the openings B-OP, G-OP, and R-OP defined in the light-blocking layer BM. The first to third color filters CF-B, CF-G, and CF-R may be spaced apart from each other on a plane. The first to third color filters CF-B, CF-G, and CF-R may be spaced apart from each other by the light-blocking layer BM.

In the display module DM according to one or more embodiments, an edge of the first color filter CF-B among the color filters CF-B, CF-G, and CF-R may partially overlap the light-blocking layer BM. For example, as illustrated in FIG. 9A, the edge(s) of the first color filter CF-B may overlap the light-blocking layer BM on a plane. In the display module DM according to one or more embodiments, the second color filter CF-G and/or the third color filter CF-R among the color filters CF-B, CF-G, and CF-R might not overlap the light-blocking layer BM on a plane.

In the display module DM according to one or more embodiments, a step may occur between an upper surface of the light-blocking layer BM and upper surfaces of the first to third color filters CF-B, CF-G, and CF-R. That is, the upper surface of the light-blocking layer BM may be higher than at least some upper surfaces of the first to third color filters CF-B, CF-G, or CF-R.

The optical layer PP may include a scattering pattern SP overlapping the second and/or third light-emitting regions PXA-G and/or PXA-R. The scattering pattern SP may overlap the second light-emitting region PXA-G and/or the third light-emitting region PXA-R, and might not overlap the first light-emitting region PXA-B. The scattering pattern SP may include a first scattering pattern SP1 overlapping the second light-emitting region PXA-G, and/or a second scattering pattern SP2 overlapping the third light-emitting region PXA-R. The first scattering pattern SP1 and the second scattering pattern SP2 may be spaced apart from each other on a plane. The first scattering pattern SP1 and the second scattering pattern SP2 may be spaced apart from each other with the light-blocking layer BM between the first scattering pattern SP1 and the second scattering pattern SP2.

The scattering pattern SP may be located under the second and third color filters CF-G and CF-R. The scattering pattern SP may be located between the display panel DP and the second and third color filters CF-G and CF-R. The second color filter CF-G may be located on the first scattering pattern SP1, and the third color filter CF-R may be located on the second scattering pattern SP2. The second color filter CF-G may be spaced apart from the display panel DP with the first scattering pattern SP1 between the second color filter CF-G and the display panel DP. The third color filter CF-R may be spaced apart from the display panel DP with the second scattering pattern SP2 between the third color filter CF-R and the display panel DP.

The scattering pattern SP may include scattering particles. The scattering pattern SP may not include a separate colorant (for example, a pigment or a dye), and may include scattering particles that scatter light within a range (e.g., predetermined range). The scattering pattern SP may include the scattering particles to scatter at least a portion of light generated from each of the second and third light-emitting elements ED-G and ED-R. The first scattering pattern SP1 may scatter at least a portion of light generated from the second light-emitting element ED-G, and the second scattering pattern SP2 may scatter at least a portion of light generated from the third light-emitting element ED-R.

In one or more embodiments, the types of the scattering particles included in the first scattering pattern SP1 may be different from or the same as the types of the scattering particles included in the second scattering pattern SP2. Additionally, the scattering particles included in each of the first scattering pattern SP1 and the second scattering pattern SP2 may have the same content or may have different contents, and the scattering particles included in each of the first scattering pattern SP1 and the second scattering pattern SP2 may have the same size or may have different sizes.

Because the display module DM according to one or more embodiments includes the scattering patterns SP1 and SP2 overlapping the second and third light-emitting regions PXA-G and PXA-R, second light emitted from the second light-emitting element ED-G, and third light emitted from the third light-emitting element ED-R may be respectively scattered to be emitted, and thus light emission properties and color purity of the display module DM may be improved.

In the display module DM according to one or more embodiments, the scattering patterns SP1 and SP2 may not be located in, or may be omitted from, the first light-emitting region PXA-B that is a region in which light having a relatively short wavelength is emitted among the light-emitting regions PXA-B, PXA-G, and PXA-R. The scattering patterns SP1 and SP2 may be respectively located in the second and third light-emitting regions PXA-G and PXA-R in which light having relatively longer wavelengths than that of the first light-emitting region PXA-B is emitted. Because the scattering patterns SP1 and SP2 overlap the second and third light-emitting regions PXA-G and PXA-R, light incident onto the second and third color filters CF-G and CF-R is scattered, and thus color differences or luminance differences according to a viewing angle may be reduced. Therefore, display quality of the electronic device EE (see FIG. 1) may be improved.

In one or more embodiments, the scattering particles may include a metal oxide. The scattering particles may include at least one of zinc oxide, titanium oxide, aluminum oxide, or silicon oxide. For example, the scattering particles may include titanium dioxide (TiO₂). However, materials of the scattering particles are not limited to the above-described range, and if suitable, the scattering particles may include various types of materials capable of scattering light in addition to the above-described materials.

The scattering patterns SP1 and SP2 may be formed in various manners. In one or more embodiments, the scattering patterns SP1 and SP2 may be formed through a photolithography process. For example, the scattering patterns SP1 and SP2 may be formed through a patterning process of a photoresist layer by performing a photolithography process.

The scattering patterns SP1 and SP2 may further include a photosensitive material. For example, the scattering patterns SP1 and SP2 may further include a polymer photosensitive resin. The scattering patterns SP1 and SP2 may include a polymer photosensitive resin, and scattering particles dispersed in the polymer photosensitive resin. The scattering patterns SP1 and SP2 may be formed of a transparent photosensitive resin and scattering particles dispersed in the transparent photosensitive resin. The polymer photosensitive resin may be a resin selected for performing the photolithography process.

The scattering patterns SP1 and SP2 may each have a single- or multi-layered structure. For example, as illustrated in FIG. 9A, the scattering patterns SP1 and SP2 may each have a single-layered structure. Additionally, the first scattering pattern SP1 overlapping the second light-emitting region PXA-G, and the second scattering pattern SP2 overlapping the third light-emitting region PXA-R, may have the same thickness. The first scattering pattern SP1 and the second scattering pattern SP2 may be formed through a single process. However, the present disclosure is not limited thereto, and the first scattering pattern SP1 and the second scattering pattern SP2 may not only have different thicknesses, but also may be formed through different processes.

In one or more embodiments, the first color filter CF-B, the scattering patterns SP1 and SP2, and the light-blocking layer BM may be located at the same layer. All the first color filter CF-B, the scattering patterns SP1 and SP2, and the light-blocking layer BM may be located on the display panel DP. The first color filter CF-B, the scattering patterns SP1 and SP2, and the light-blocking layer BM may each be located on the uppermost layer of a plurality of functional layers included in the display panel DP. As illustrated in FIG. 9A, the first color filter CF-B, the scattering patterns SP1 and SP2, and the light-blocking layer BM may each be located on the encapsulation layer TFE. The first color filter CF-B, the scattering patterns SP1 and SP2, and the light-blocking layer BM may each be directly located on the encapsulation layer TFE.

Referring to FIG. 9B, a lower surface L-CB of the first color filter CF-B may be parallel to, or aligned with, lower surfaces L-S1 and L-S2 of the scattering patterns SP1 and SP2 and a lower surface L-BM of the light-blocking layer BM. That is, the lower surface L-CB of the first color filter CF-B, the lower surfaces L-S1 and L-S2 of the scattering patterns SP1 and SP2, and the lower surface L-BM of the light-blocking layer BM may be located on the same line (e.g., may be coplanar). The lower surface L-CB of the first color filter CF-B, the lower surfaces L-S1 and L-S2 of the scattering patterns SP1 and SP2, and the lower surface L-BM of the light-blocking layer BM may have the same level.

The light-blocking layer BM may be located between the color filters CF-B, CF-G, and CF-R, and may contact each of the color filters CF-B, CF-G, and CF-R. Additionally, the light-blocking layer BM may be located between the first scattering pattern SP1 and the second scattering pattern SP2, and may contact each of the first scattering pattern SP1 and the second scattering pattern SP2.

In one or more embodiments, the light-blocking layer BM may cover a side surface of each of the color filters CF-B, CF-G, and CF-R. The light-blocking layer BM may contact each of the side surface of the first color filter CF-B, the side surface of the second color filter CF-G, and the side surface of the third color filter CF-R. Furthermore, the light-blocking layer BM may cover side surfaces of the scattering patterns SP1 and SP2. The light-blocking layer BM may contact each of the side surface of the first scattering pattern SP1 and the side surface of the second scattering pattern SP2. In one or more embodiments, the light-blocking layer BM may cover each of the entire side surfaces of the scattering patterns SP1 and SP2 and the entire side surface of the first color filter CF-B.

The first color filter CF-B among the color filters CF-B, CF-G, and CF-R is formed through a photolithography process, and the other second color filter CF-G and the third color filter CF-R may be formed through an inkjet process.

The first color filter CF-B may be formed through a photolithography process. After a photoresist composition is provided, the photoresist composition is patterned, and then the first color filter CF-B may be formed. The second and third color filters CF-G and CF-R may each be formed through an inkjet process. After a liquid ink composition is provided into each of the second and third openings G-OP and R-OP, the provided ink composition is polymerized through a thermal curing process or a photocuring process, and then the second and third color filters CF-G and CF-R may be formed. Because the first color filter CF-B is formed through a photolithography process, a photosensitive resin may be included.

The first color filter CF-B is formed through one photolithography process so as to correspond to each of the plurality of first light-emitting regions PXA-B. In one or more embodiments, the thickness variation of the first color filter CF-B may be less than the thickness variation of each of the second color filter CF-G and the third color filter CF-R. As described above, the second color filter CF-G and the third color filter CF-R may be formed by providing a liquid composition to each of the second light-emitting region PXA-G and the third light-emitting region PXA-R. Because the liquid composition is provided discontinuously, a weight variation may occur in the provided liquid composition. Therefore, the thickness variation of each of the second color filter CF-G and the third color filter CF-R may be relatively larger than the thickness variation of the first color filter CF-B.

A portion of the light-blocking layer BM partially overlaps the first color filter CF-B on a plane. A portion of the light-blocking layer BM overlaps the first color filter CF-B on a plane. In the optical layer PP according to one or more embodiments, the light-blocking layer BM may overlap the first color filter CF-B formed through a photolithography process on a plane. A portion of the light-blocking layer BM may be located on the first color filter CF-B.

Referring to FIGS. 9A and 9B, the first to third openings B-OP, G-OP, and R-OP that respectively correspond to the first to third light-emitting regions PXA-B, PXA-G, and PXA-R, may be defined in (e.g., defined by) the light-blocking layer BM. The first opening B-OP may overlap the first light-emitting region PXA-B, the second opening G-OP may overlap the second light-emitting region PXA-G, and the third opening R-OP may overlap the third light-emitting region PXA-R.

Referring to FIG. 9B, the first opening B-OP in which the first color filter CF-B is located may be defined to have a plurality of portions. A first inner side surface of the light-blocking layer BM that defines the first opening B-OP may include, in the first direction DR1, a (1-1)-th portion overlapping the first color filter CF-B, and a (1-2)-th portion not overlapping the first color filter CF-B. The first opening B-OP may include a (1-1)-th opening B-OP1 defined by the (1-1)-th portion, and a (1-2)-th opening B-OP2 defined by the (1-2)-th portion. The width of the (1-1)-th opening B-OP1 may be different from the width of the (1-2)-th opening B-OP2 in the first direction DR1 perpendicular to a thickness direction. The width of the (1-2)-th opening B-OP2 may be less than the width of the (1-1)-th opening B-OP1. A (1-2)-th inner side surface of the light-blocking layer BM defining the (1-2)-th opening B-OP2 may be further adjacent to the center of the first color filter CF-B than a (1-1)-th inner side surface.

Referring to FIG. 9B, in one or more embodiments, the width W_{C1} of the first color filter CF-B may be larger than the width W_{P1} of the first opening B-OP in the first direction DR1. At this point, the width W_{P1} of the first opening B-OP may mean the width of the (1-2)-th opening B-OP2. Because a portion of the light-blocking layer BM partially covers the upper surface of the first color filter CF-B, the width W_{P1} of the first opening B-OP may be less than the width W_{C1} of the first color filter CF-B.

A portion of the light-blocking layer BM may partially overlap each of the scattering patterns SP1 and SP2 on a plane. A portion of the light-blocking layer BM may partially overlap each of the first and second scattering patterns SP1 and SP2 on a plane. In the optical layer PP according to one or more embodiments, the first and second scattering patterns SP1 and SP2 are formed through a photolithography process. On a plane, the light-blocking layer BM may overlap each of the first and second scattering patterns SP1 and SP2 that are formed through a photolithography process. A portion of the light-blocking layer BM may be located on each of the first and second scattering patterns SP1 and SP2.

The second and third openings G-OP and R-OP respectively overlapping the second and third light-emitting regions PXA-G and PXA-R may each be defined to have a plurality of portions.

A second inner side surface of the light-blocking layer BM defining the second opening G-OP may include, in the first direction DR1, a (2-1)-th portion overlapping the first scattering pattern SP1, and a (2-2)-th portion not overlapping the first scattering pattern SP1. The second opening G-OP may include a (2-1)-th opening G-OP1 defined by the (2-1)-th portion, and a (2-2)-th opening G-OP2 defined by the (2-2)-th portion. The first scattering pattern SP1 may be located within the (2-1)-th opening G-OP1, and the second color filter CF-G may be located within the (2-2)-th opening G-OP2. The width of the (2-1)-th opening G-OP1 may be different from the width of the (2-2)-th opening G-OP2 in the first direction DR1 perpendicular to the thickness direction. The width of the (2-2)-th opening G-OP2 may be less than the width of the (2-1)-th opening G-OP1.

A third inner side surface of the light-blocking layer BM that defines the third opening R-OP may include, in the first direction DR1, a (3-1)-th portion overlapping the second scattering pattern SP2, and a (3-2)-th portion not overlapping the second scattering pattern SP2. The third opening R-OP may include a (3-1)-th opening R-OP1 defined by the (3-1)-th portion, and a (3-2)-th opening R-OP2 defined by the (3-2)-th portion. The second scattering pattern SP2 may be located within the (3-1)-th opening R-OP1, and the third color filter CF-R may be located within the (3-2)-th opening R-OP2. The width of the (3-1)-th opening R-OP1 may be different from the width of the (3-2)-th opening R-OP2 in the first direction DR1 perpendicular to the thickness direction. The width of the (3-2)-th opening R-OP2 may be less than the width of the (3-1)-th opening R-OP1.

In one or more embodiments, the width W_{S1} of the first scattering pattern SP1 may be greater than the width W_{P2} of the second opening G-OP in the first direction DR1. In this case, the width W_{P2} of the second opening G-OP may mean the width of the (2-2)-th opening G-OP2. Additionally, the width W_{S2} of the second scattering pattern SP2 may be greater than the width W_{P3} of the third opening R-OP. In this case, the width W_{P3} of the third opening R-OP may mean the width of the (3-2)-th opening R-OP2.

As illustrated in FIGS. 9A and 9B, an upper surface U-CB of the first color filter CF-B may be lower than each of upper surfaces U-CG and U-CR respectively of the second and third color filters CF-G and CF-R. That is, the upper surface U-CB of the first color filter CF-B may be closer to the display panel DP than are the upper surfaces U-CG and U-CR of the respective second and third color filters CF-G and CF-R. The first upper surface U-CB of the first color filter CF-B may be lower than each of a second upper surface U-CG of the second color filter CF-G and a third upper surface U-CR of the third color filter CF-R. As the first and second scattering patterns SP1 and SP2 are respectively located under the second and third color filters CF-G and CF-R, the upper surfaces U-CG and U-CR of the respective second and third color filters CF-G and CF-R may be higher than the upper surface U-CB of the first color filter CF-B.

The light-blocking layer BM may not be located on, or might not overlap, the upper surfaces U-CG and U-CR of the second and third color filters CF-G and CF-R. The light-blocking layer BM may contact only a side surface of each of the second and third color filters CF-G and CF-R, and may not contact the upper surfaces U-CG and U-CR. The light-blocking layer BM may not be located on either the second upper surface U-CG of the second color filter CF-G or the third upper surface U-CR of the third color filter CF-R.

The second and third color filters CF-G and CF-R may respectively be located on the first and second scattering patterns SP1 and SP2. The second color filter CF-G may be located on the first scattering pattern SP1, and the third color filter CF-R may be located on the second scattering pattern SP2. The second color filter CF-G may be directly located on the first scattering pattern SP1, and the third color filter CF-R may be directly located on the second scattering pattern SP2. The second color filter CF-G may cover a portion of an upper surface U-S1 of the first scattering pattern SP1 that is exposed by the (2-2)-th opening G-OP2. The third color filter CF-R may cover a portion of an upper surface U-S2 of the second scattering pattern SP2 that is exposed by the (3-2)-th opening R-OP2.

In one or more embodiments, the width W_{C2} of the second color filter CF-G may be the substantially same as the width W_{P2} of the second opening G-OP in the first direction DR1. In this case, the width W_{P2} of the second opening G-OP may mean the width of the (2-2)-th opening G-OP2. Additionally, the width W_{C3} of the third color filter CF-R may be the substantially same as the width W_{P3} of the third opening R-OP. In this case, the width W_{P3} of the third opening R-OP may mean the width of the (3-2)-th opening R-OP2. In this specification, the wording "the substantially same" includes a case where components have the completely same value of each of a thickness, a length, a width, etc., as well as a case where, in spite of being identically designed, components have the same value within a range of differences that may occur due to a process tolerance.

In the display module DM according to one or more embodiments, the optical layer PP may further include an overcoat layer OC located on the color filter CF. The overcoat layer OC may be located on the first to third color filters CF-B, CF-G, and CF-R.

The overcoat layer OC may be an organic layer that protects the first to third color filters CF-B, CF-G, and CF-R. The overcoat layer OC may cover the first to third color filters CF-B, CF-G, and CF-R, and may planarize the upper surfaces U-CB, U-CG and U-CR of the first to third color filters CF-B, CF-G, and CF-R. In one or more embodiments, the overcoat layer OC may cover each of the upper surfaces U-CB, U-CG and U-CR of the first to third color filters CF-B, CF-G, and CF-R and an upper surface U-BM of the light-blocking layer BM. The overcoat layer OC may cover each of the first upper surface U-CB of the first color filter CF-B, the second upper surface U-CG of the second color filter CF-G, the third upper surface U-CR of the third color filter CF-R, and the upper surface U-BM of the light-blocking layer BM. The overcoat layer OC may include a photocurable organic material or a thermosetting organic material. However, materials included in the overcoat layer OC are not limited thereto, and the overcoat layer OC may also include inorganic materials.

In one or more embodiments, the display module DM may further include the base substrate BL located on the color filter CF. The base substrate BL may be located on the overcoat layer OC. The base substrate BL may be a glass substrate, a metal substrate, a plastic substrate, etc. However, the present disclosure is not limited thereto, and the base substrate BL may be an inorganic layer, an organic layer, or a composite material layer. Additionally, unlike what is illustrated in the drawing, in one or more embodiments, the base substrate BL may be omitted.

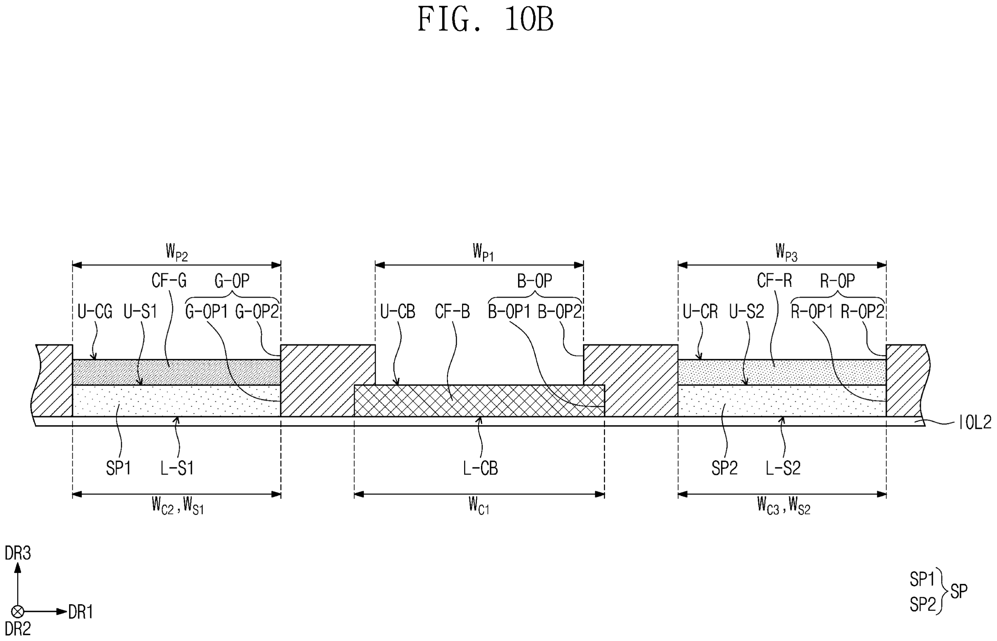

FIG. 10A is an enlarged cross-sectional view illustrating a partial region of a display module according to one or more embodiments of the present disclosure. FIG. 10B is an enlarged cross-sectional view illustrating a portion of some components of the display module according to one or more embodiments of the present disclosure. FIG. 10A illustrates a cross section taken along the line III-III' of FIG. 5. FIG. 10B illustrates a cross section taken along the line III-III' of FIG. 5, focusing on the components included in an optical layer PP of the display module according to one or more embodiments.

FIG. 10A illustrates a display module DM-1 according to one or more embodiments different from that of the display module DM illustrated in FIG. 9A. The display module DM-1, according to one or more embodiments, illustrated in FIG. 10A differs in a shape of the scattering pattern SP from the display module DM, according to one or more embodiments, illustrated in FIG. 9A.

Referring to FIGS. 10A and 10B, in the display module DM-1 according to one or more embodiments, an optical layer PP may include a scattering pattern SP overlapping second and third light-emitting regions PXA-G and PXA-R. The scattering pattern SP may overlap the second light-emitting region PXA-G and the third light-emitting region PXA-R, and might not overlap a first light-emitting region PXA-B.

The scattering pattern SP may include a first scattering pattern SP1 overlapping the second light-emitting region PXA-G, and a second scattering pattern SP2 overlapping the third light-emitting region PXA-R. The first scattering pattern SP1 and the second scattering pattern SP2 may be spaced apart from each other on a plane. The first scattering pattern SP1 and the second scattering pattern SP2 may be spaced apart from each other with a light-blocking layer BM between the first scattering pattern SP1 and the second scattering pattern SP2.

The light-blocking layer BM might not overlap the scattering patterns SP1 and SP2 on a plane. The light-blocking layer BM might not overlap either the first scattering pattern SP1 or the second scattering pattern SP2 on a plane. The light-blocking layer BM may not be located on upper surfaces U-S1 and U-S2 of the first and second scattering patterns SP1 and SP2. The light-blocking layer BM may contact only a side surface of each of the first and second scattering patterns SP1 and SP2, and may not contact the upper surfaces U-S1 and U-S2. The light-blocking layer BM may not be located on either the upper surface U-S1 of the first scattering pattern SP1 or the upper surface U-S2 of the second scattering pattern SP2.

In the display module DM-1, according to one or more embodiments, illustrated in FIGS. 10A and 10B, a second inner side surface of the light-blocking layer BM defining a second opening G-OP may include, in the first direction DR1, a (2-1)-th portion overlapping the first scattering pattern SP1 and a (2-2)-th portion not overlapping the first scattering pattern SP1. The second opening G-OP may include a (2-1)-th opening G-OP1 defined by the (2-1)-th portion, and a (2-2)-th opening G-OP2 defined by the (2-2)-th portion. The first scattering pattern SP1 may be located within the (2-1)-th opening G-OP1, and the second color filter CF-G may be located within the (2-2)-th opening G-OP2. The width of the (2-1)-th opening G-OP1 may be the substantially same as the width of the (2-2)-th opening G-OP2 in the first direction DR1 perpendicular to the thickness direction.

A third inner side surface of the light-blocking layer BM defining the third opening R-OP may include, in the first direction DR1, a (3-1)-th portion overlapping the second scattering pattern SP2, and a (3-2)-th portion not overlapping the second scattering pattern SP2. The third opening R-OP may include a (3-1)-th opening R-OP1 defined by the (3-1)-th portion, and a (3-2)-th opening R-OP2 defined by the (3-2)-th portion. The second scattering pattern SP2 may be located within the (3-1)-th opening R-OP1, and the third color filter CF-R may be located within the (3-2)-th opening R-OP2. The width of the (3-1)-th opening R-OP1 may be the substantially same as the width of the (3-2)-th opening R-OP2 in the first direction DR1 perpendicular to the thickness direction.

Referring to FIG. 10B, in one or more embodiments, the width W_{S1} of the first scattering pattern SP1 may be the substantially same as the width W_{P2} of the second opening G-OP in the first direction DR1. In this case, the width W_{P2} of the second opening G-OP may mean the width of the (2-2)-th opening G-OP2. Additionally, the width W_{S2} of the second scattering pattern SP2 may be the substantially same as the width W_{P3} of the third opening R-OP. In this case, the width W_{P3} of the third opening R-OP may mean the width of the (3-2)-th opening R-OP2.

The second and third color filters CF-G and CF-R may respectively be located on the first and second scattering patterns SP1 and SP2. The second color filter CF-G may be located on the first scattering pattern SP1, and the third color filter CF-R may be located on the second scattering pattern SP2. The second color filter CF-G may be directly located on the first scattering pattern SP1, and the third color filter CF-R may be directly located on the second scattering pattern SP2.

The second color filter CF-G may cover the entire upper surface U-S1 of the first scattering pattern SP1. As the light-blocking layer BM is not located on the upper surface US1 of (e.g., does not overlap) the first scattering pattern SP1, the entire upper surface U-S1 of the first scattering pattern SP1 may be exposed by the (2-2)-th opening G-OP2, and the second color filter CF-G may cover the entire exposed upper surface U-S1 of the first scattering pattern SP1. Additionally, the third color filter CF-R may cover the entire upper surface U-S2 of the second scattering pattern SP2. As the light-blocking layer BM is not located on the upper surface U-S2 of (e.g., does not overlap) the second scattering pattern SP2, the entire upper surface U-S2 of the second scattering pattern SP2 may be exposed by the (3-2)-th opening R-OP2, and the third color filter CF-R may cover the entire exposed upper surface U-S2 of the second scattering pattern SP2.

In the display module DM-1, according to one or more embodiments, illustrated in FIGS. 10A and 10B, the scattering patterns SP1 and SP2 may be formed through an inkjet process. For example, a liquid composition is provided into the openings G-OP and R-OP, and then the scattering patterns SP1 and SP2 may be formed through a curing process.

The scattering patterns SP1 and SP2 may include a base resin, and scattering particles dispersed in the base resin. The base resin may be a medium in which the scattering particles are dispersed, and may be composed of various resin compositions capable of generally being referred to as a binder. The base resin may be an acrylate-based resin, a urethane-based resin, a silicone-based resin, an epoxy-based resin, etc. The base resin may be a resin selected for performing an inkjet process.

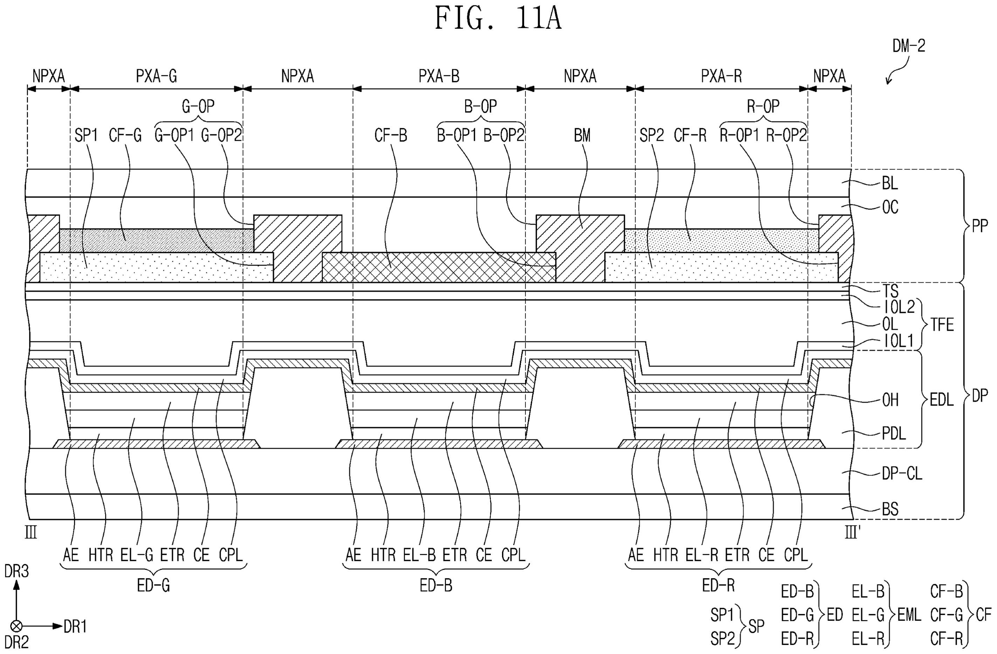

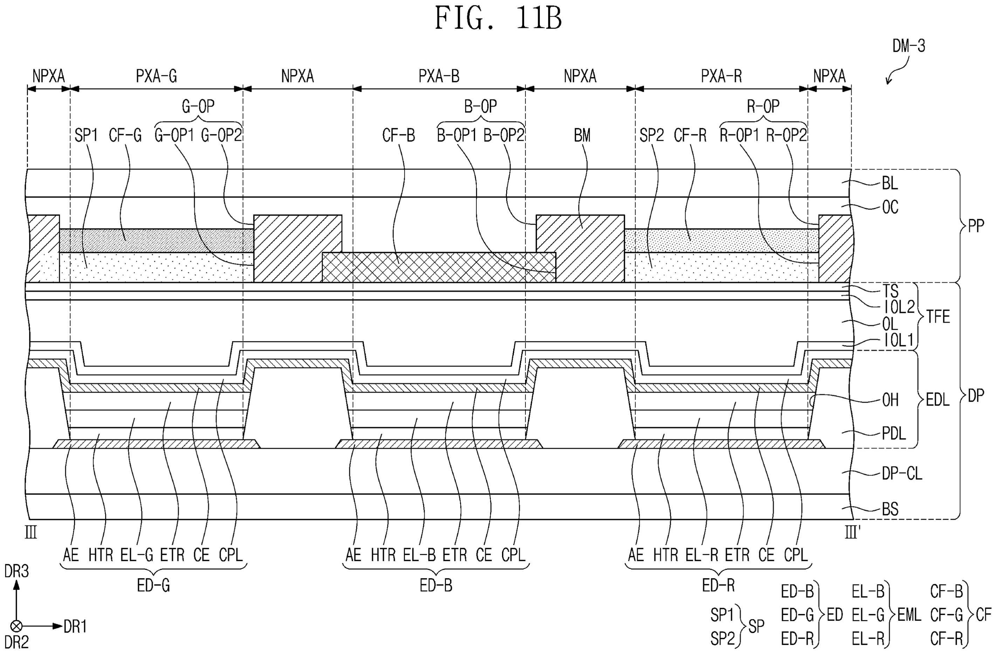

FIGS. 11A and 11B are enlarged cross-sectional views illustrating a partial region of a display module according to one or more embodiments of the present disclosure. FIGS. 11A and 11B respectively illustrate cross sections taken along the line III-III' of FIG. 5.

FIGS. 11A and 11B respectively illustrate display modules DM-2 and DM-3 according to embodiments different from those of the display modules DM and DM-1 illustrated in FIGS. 9A and 10A. The display module DM-2, according to one or more embodiments, illustrated in FIG. 11A differs from the display module DM, according to one or more embodiments, illustrated in FIG. 9A in that a touch sensor TS is further included. The display module DM-3, according to one or more embodiments, illustrated in FIG. 11B differs from the display module DM-1, according to one or more embodiments, illustrated in FIG. 10A in that the touch sensor TS is further included.

Referring to FIGS. 11A and 11B, a display panel DP may also further include the touch sensor TS located between an optical layer PP and an encapsulation layer TFE. In one or more embodiments, a first color filter CF-B, scattering patterns SP1 and SP2, and a light-blocking layer BM may be located at the same layer. As illustrated in FIGS. 11A and 11B, the first color filter CF-B, the scattering patterns SP1 and SP2, and the light-blocking layer BM may each be located on the touch sensor TS. The first color filter CF-B, the scattering patterns SP1 and SP2, and the light-blocking layer BM may each be directly located on the touch sensor TS.

Hereinafter, a method for manufacturing a display device according to one or more embodiments of the present disclosure will be described.

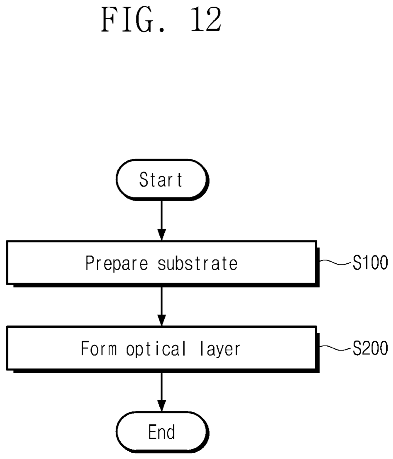

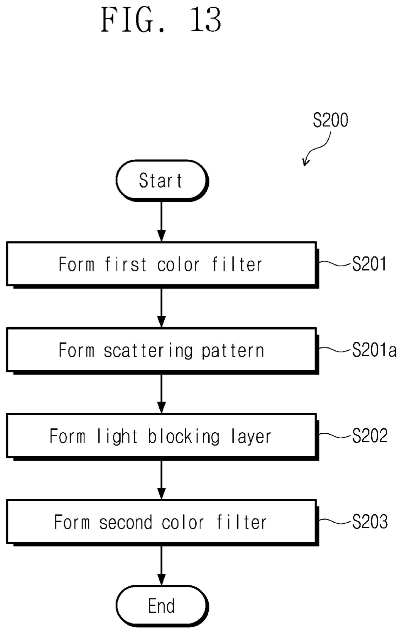

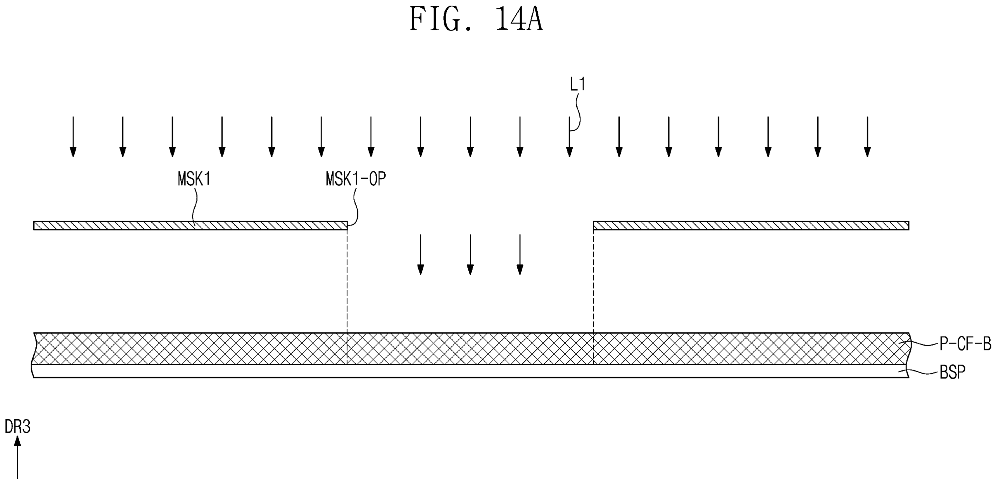

FIG. 12 is a flowchart of a method for manufacturing a display device according to one or more embodiments of the present disclosure. FIG. 13 is a flowchart of some operations in the method for manufacturing a display device according to one or more embodiments of the present disclosure. FIG. 13 is a flowchart of an operation of forming an optical layer (S200) in the method for manufacturing the display device according to one or more embodiments of the present disclosure. FIGS. 14A to 14J are cross-sectional views illustrating some operations in a method for manufacturing the display device according to one or more embodiments of the present disclosure. FIGS. 14A to 14J briefly illustrate some operations of forming an optical layer in the method for manufacturing a display device according to one or more embodiments.

Hereinafter, when describing the method for manufacturing a display device according to one or more embodiments with reference to FIGS. 12, 13, and 14A to 14J, the same reference numerals or symbols are used for the components duplicated with those described above, and a detailed description thereof will be omitted.

Referring to FIG. 12, a method for manufacturing a display device according to one or more embodiments includes an operation of preparing a substrate that includes a light-emitting element (S100), and an operation of forming an optical layer on the substrate (S200).

Referring to FIG. 13, the operation of forming the optical layer according to one or more embodiments (S200) includes operations of: forming a first color filter overlapping a first light-emitting region by patterning a first preliminary color filter including a photosensitive material (S201); forming a scattering pattern overlapping a second light-emitting region (S201a); forming a light-blocking layer in which a first opening overlapping the first light-emitting region and a second opening overlapping the second light-emitting region are defined (S202); and forming a second color filter on the scattering pattern in the second opening through an inkjet process (S203).

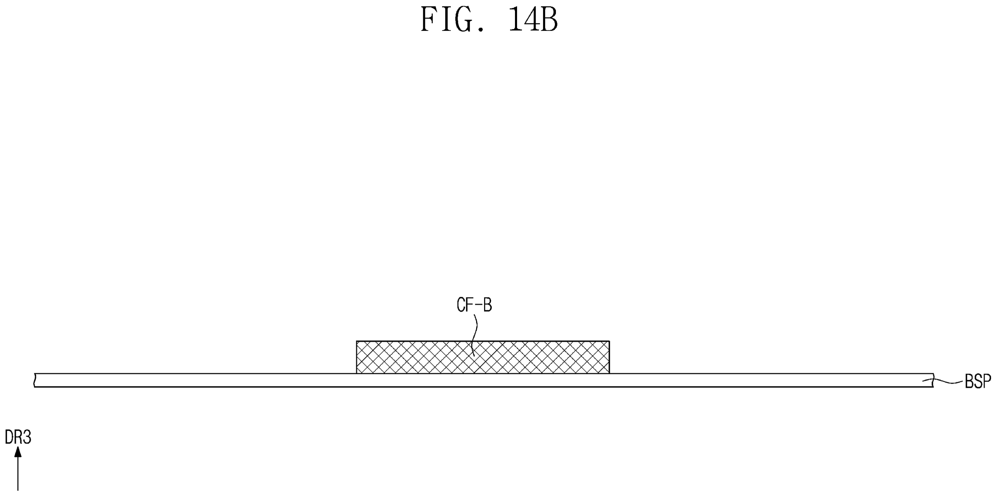

Referring to FIGS. 14A and 14B, a method for manufacturing a display device according to one or more embodiments includes an operation of forming a first color filter CF-B. The first color filter CF-B may be formed on a substrate BSP.

The substrate BSP may be a member that provides a base surface on which the color filters CF-B, CF-G, and CF-R (see FIG. 9A) and the light-blocking layer BM (see FIG. 9A) are formed. The substrate BSP may provide a reference surface on which the color filters CF-B, CF-G, and CF-R (see FIG. 9A), the scattering patterns SP1 and SP2 (see FIG. 9A), and the light-blocking layer BM (see FIG. 9A) are formed.

The substrate BSP may include the display panel DP illustrated in FIG. 9A, and the color filters CF-B, CF-G, and CF-R (see FIG. 9A), the scattering patterns SP1 and SP2 (see FIG. 9A), and the light-blocking layer BM (see FIG. 9A) may be formed on a reference surface that is provided from the uppermost layer of a plurality of functional layers included in the display panel DP (see FIG. 9A). For example, the color filters CF-B, CF-G, and CF-R (see FIG. 9A), the scattering patterns SP1 and SP2 (see FIG. 9A), and the light-blocking layer BM (see FIG. 9A) may be formed on a reference surface that is provided from the encapsulation layer TFE (see FIG. 9A) included in the display panel DP. Additionally, when the display panel DP (see FIG. 11A) further includes the touch sensor TS (see FIG. 11A), the color filters CF-B, CF-G, and CF-R (see FIG. 11A), the scattering patterns SP1 and SP2 (see FIG. 11A), and the light-blocking layer BM (see FIG. 11A) may also be formed on a reference surface that is provided from the touch sensor TS (see FIG. 11A).

Referring to FIG. 14A, a first preliminary color filter P-CF-B may be formed on the substrate BSP. The first preliminary color filter P-CF-B may be formed by coating a first photoresist composition on the substrate BSP. The first photoresist composition may include a photosensitive material. The first preliminary color filter P-CF-B formed of the first photoresist composition including a photosensitive material may have physical properties that vary according to whether light irradiation is performed. The first photoresist composition may further include a blue pigment or a blue dye.

The first preliminary color filter P-CF-B may be formed to overlap the plurality of light-emitting regions PXA-B, PXA-G, and PXA-R (see FIG. 9A) and the non-light-emitting region NPXA (see FIG. 9A). The first preliminary color filter P-CF-B may be provided to have a constant thickness on the substrate BSP.

Subsequently, the first preliminary color filter P-CF-B is patterned, and then an operation of forming the first color filter CF-B may be performed. As illustrated in FIGS. 14A and 14B, the first preliminary color filter P-CF-B may be patterned through a photolithography process.

A first mask MSK1 may be located on the first preliminary color filter P-CF-B to pattern the first preliminary color filter P-CF-B. A first mask opening MSK1-OP corresponding to the first light-emitting region PXA-B may be defined in the first mask MSK1.

The first mask MSK1 may include regions having different light transmittances within the first mask MSK1. The first mask MSK1 may include a transmission part and a light-blocking part. The transmission part may be a region through which light emitted from above the first mask MSK1 is transmitted. The transmission part may correspond to a region in which the first mask opening MSK1-OP is defined. The light-blocking part may be a region in which light emitted from above the first mask MSK1 is blocked.

First light L1 transmitted through the first mask opening MSK1-OP of the first mask MSK1 may be provided to the first preliminary color filter P-CF-B. A portion of the first preliminary color filter P-CF-B may be cured by the first light L1 that is provided through the first mask opening MSK1-OP. The portion of the first preliminary color filter P-CF-B, which is provided with the first light L1 transmitted through the first mask opening MSK1-OP, may be cured. After the first light L1 transmitted through the first mask MSK1 is provided to the first preliminary color filter P-CF-B, the first preliminary color filter P-CF-B is cured according to a pattern of the first mask MSK1, and then the patterned first color filter CF-B may be formed. In one or more embodiments, the first light L1 may be ultraviolet (UV) light, but is not limited thereto.

Thereafter, the first preliminary color filter P-CF-B exposed through the first mask MSK1 is developed, and then as illustrated in FIG. 14B, a portion of the first preliminary color filter P-CF-B, in which the first light L1 transmitted through the first mask opening MSK1-OP is provided, may not be removed and may remain. The portion of the first preliminary color filter P-CF-B, which overlaps the first mask opening MSK1-OP, may form the first color filter CF-B illustrated in FIG. 14B. A portion of the first preliminary color filter P-CF-B, which does not overlap the first mask opening MSK1-OP, may block the first light L1. After the first preliminary color filter P-CF-B exposed through the first mask MSK1 is developed, the portion of the first preliminary color filter P-CF-B, in which the first light L1 is not provided, may be completely removed.

FIGS. 14A and 14B illustrate a case in which a negative photosensitive solution is used for removing the first preliminary color filter P-CF-B in an unexposed portion, but the present disclosure is not limited thereto. In one or more embodiments, a positive photosensitive solution may also be used for removing a photosensitive film in an exposed portion.

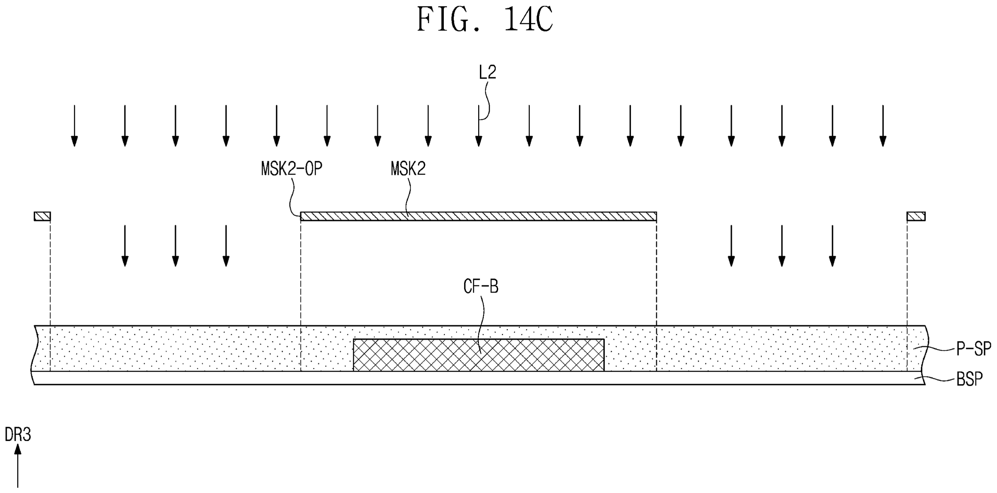

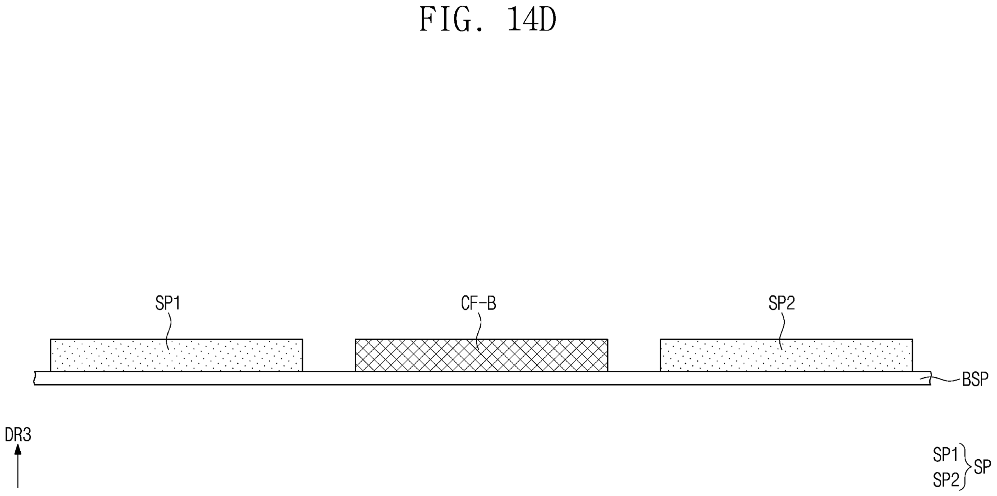

Referring to FIGS. 14C and 14D, a method for manufacturing a display device according to one or more embodiments includes an operation of forming a scattering pattern. After the first color filter CF-B is formed, an operation of forming the scattering pattern SP may be performed. In a method for manufacturing a display device, according to one or more embodiments, described with reference to FIGS. 14A to 14J, the scattering pattern SP may be performed before the operation of forming the light-blocking layer (S202).

Referring to FIG. 14C, a preliminary scattering pattern P-SP may be formed on the substrate BSP. The preliminary scattering pattern P-SP may be formed by coating, on the substrate BSP, a second photoresist composition including scattering particles. The second photoresist composition may include a photosensitive material and scattering particles. The preliminary scattering pattern P-SP formed of the second photoresist composition including a photosensitive material may have physical properties that vary according to whether light irradiation is performed.

The preliminary scattering pattern P-SP may be formed to overlap the plurality of light-emitting regions PXA-B, PXA-G, and PXA-R (see FIG. 9A) and the non-light-emitting region NPXA (see FIG. 9A). The preliminary scattering pattern P-SP may be formed to overlap at least the second light-emitting region PXA-G (see FIG. 9A) and the third light-emitting region PXA-R (see FIG. 9A). Additionally, the preliminary scattering pattern P-SP may be formed to overlap the first light-emitting region PXA-B (see FIG. 9A), and also may at least partially cover the first color filter CF-B as illustrated in FIG. 14C. The preliminary scattering pattern P-SP may be provided on the substrate BSP so as to have a constant thickness.

Thereafter, the preliminary scattering pattern P-SP is patterned, and then an operation of forming the scattering pattern SP may be performed. As illustrated in FIGS. 14C and 14D, the preliminary scattering pattern P-SP may be patterned through a photolithography process. A second mask MSK2 may be located on the preliminary scattering pattern P-SP to pattern the preliminary scattering pattern P-SP. A second mask opening MSK2-OP corresponding to the second light-emitting region PXA-G (see FIG. 9A) and the third light-emitting region PXA-R (see FIG. 9A) may be defined in the second mask MSK2. Second light L2 transmitted through the second mask opening MSK2-OP of the second mask MSK2 may be provided to the preliminary scattering pattern P-SP. A portion of the preliminary scattering pattern P-SP, which is provided with the second light L2 transmitted through the second mask opening MSK2-OP, may be cured.

Thereafter, the preliminary scattering pattern P-SP exposed through the second mask MSK2 is developed, and then as illustrated in FIG. 14D, a portion of the preliminary scattering pattern P-SP, which is provided with the second light L2 transmitted through the second mask opening MSK2-OP, may not be removed and may remain. A portion of the preliminary scattering pattern P-SP, which overlaps the second mask opening MSK2-OP, may form the scattering patterns SP1 and SP2 illustrated in FIG. 14D. A portion of the preliminary scattering pattern P-SP, which does not overlap the second mask opening MSK2-OP, may block the second light L2. After the preliminary scattering pattern P-SP exposed through the second mask MSK2 is developed, the portion of the preliminary scattering pattern P-SP, in which the second light L2 is not provided, may be completely removed.

FIGS. 14C and 14D illustrate a case in which the first scattering pattern SP1 and the second scattering pattern SP2 are formed through the same photolithography process in the method for manufacturing the display device according to one or more embodiments. However, the present disclosure is not limited thereto, and the first scattering pattern SP1 and the second scattering pattern SP2 may be formed through a separate photolithography process. For example, after a first photolithography process of forming the first scattering pattern SP1 is performed, a second photolithography process of forming the second scattering pattern SP2 may be performed, but the present disclosure is not limited thereto.

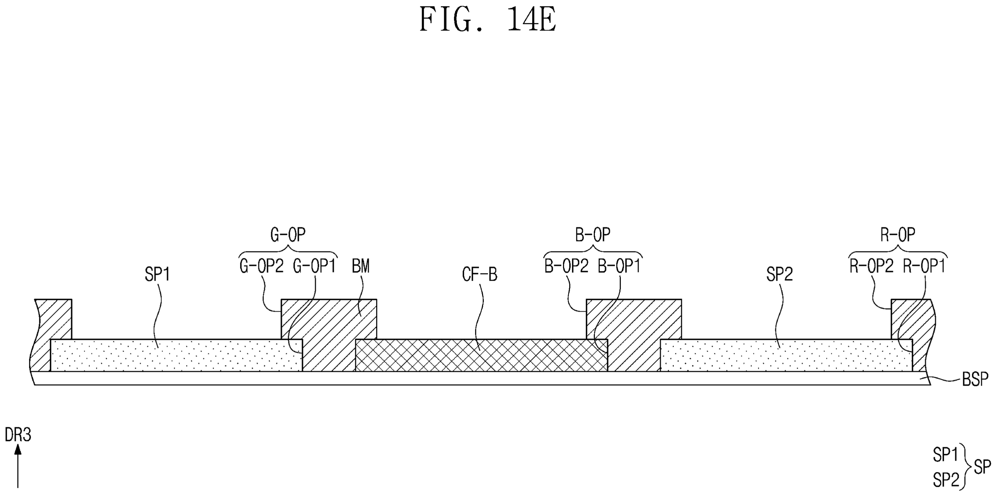

Referring to FIG. 14E, a method for manufacturing a display device according to one or more embodiments includes an operation of forming the light-blocking layer BM in which openings B-OP, G-OP, and R-OP are defined. The light-blocking layer BM may be formed on the substrate BSP.

In the method for manufacturing the display device according to one or more embodiments, the operation of forming the light-blocking layer BM may include operations of: forming a preliminary light-blocking layer on a substrate BSP; and forming, by patterning the preliminary light-blocking layer, the light-blocking layer BM in which first to third openings BOP, G-OP, and R-OP respectively overlapping the first to third light-emitting regions PXA-B, PXA-G, and PXA-R (see FIG. 9A) are defined. The preliminary light-blocking layer is formed on the substrate BSP, and then the light-blocking layer BM may be formed by patterning each of the first opening B-OP, the second opening G-OP, and the third opening R-OP.

In the operation of forming the light-blocking layer BM, the openings B-OP, G-OP, and R-OP corresponding to the plurality of light-emitting regions PXA-B, PXA-G, and PXA-R (see FIG. 9A) may be formed in the light-blocking layer BM. The first to third openings B-OP, G-OP, and R-OP, which respectively correspond to the first to third light-emitting regions PXA-B, PXA-G, and PXA-R (see FIG. 9A), may be defined in the light-blocking layer BM. In the operation of forming the light-blocking layer BM, the openings B-OP, G-OP, and R-OP corresponding to the plurality of light-emitting regions PXA-B, PXA-G, and PXA-R (see FIG. 9A) may be formed. That is, in the operation of forming the light-blocking layer BM, the first opening B-OP corresponding to the first light-emitting region PXA-B (see FIG. 9A), the second opening G-OP corresponding to the second light-emitting region PXA-G (see FIG. 9A), and the third opening R-OP corresponding to the third light-emitting region PXA-R (see FIG. 9A) may be formed.

Referring to FIG. 14E, the light-blocking layer BM may be formed to partially overlap the first color filter CF-B on a plane. A portion of the light-blocking layer BM may be located on the first color filter CF-B. The light-blocking layer BM may partially cover an upper surface of the first color filter CF-B, and may be located on the first color filter CF-B. The light-blocking layer BM may partially contact the upper surface of the first color filter CF-B. Additionally, the light-blocking layer BM may be formed to partially overlap the scattering patterns SP1 and SP2 on a plane. A portion of the light-blocking layer BM may be located on each of the first scattering pattern SP1 and the second scattering pattern SP2. The light-blocking layer BM may partially cover the upper surface of each of the first scattering pattern SP1 and the second scattering pattern SP2, and may be located on each of the first scattering pattern SP1 and the second scattering pattern SP2. The light-blocking layer BM may partially contact the upper surface of each of the first scattering pattern SP1 and second scattering pattern SP2.

The openings B-OP, G-OP, and R-OP formed in the light-blocking layer BM may each be defined to have a plurality of portions.

A first inner side surface of the light-blocking layer BM that defines a first opening B-OP may include a (1-1)-th portion overlapping the first color filter CF-B, and a (1-2)-th portion not overlapping the first color filter CF-B in a direction perpendicular to the thickness direction. The first opening B-OP may include a (1-1)-th opening B-OP1 defined by the (1-1)-th portion, and a (1-2)-th opening B-OP2 defined by the (1-2)-th portion.

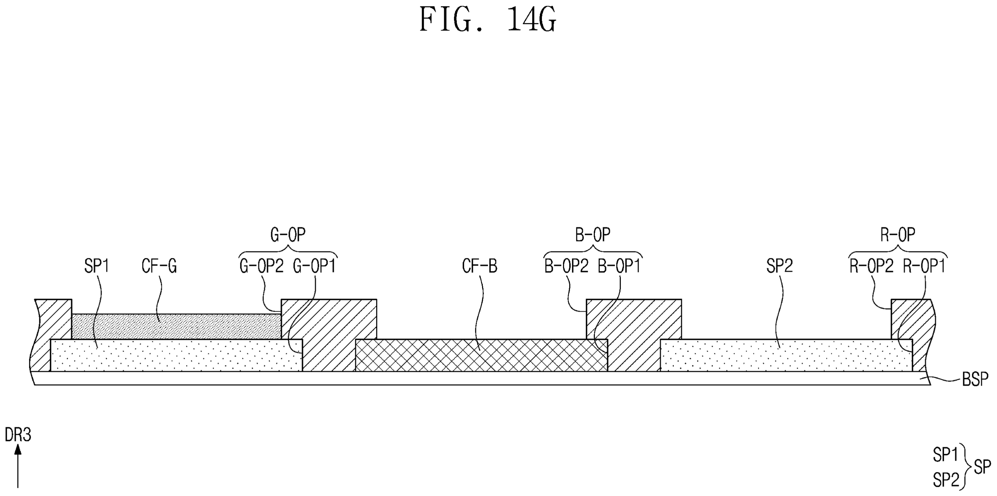

A second inner side surface of the light-blocking layer BM that defines a second opening G-OP may include a (2-1)-th portion overlapping the first scattering pattern SP1, and a (2-2)-th portion not overlapping the first scattering pattern SP1 in the direction perpendicular to the thickness direction. The second opening G-OP may include a (2-1)-th opening G-OP1 defined by the (2-1)-th portion, and a (2-2)-th opening G-OP2 defined by the (2-2)-th portion. The second color filter CF-G (see FIG. 14G) to be described later may be formed within the (2-2)-th opening G-OP2.

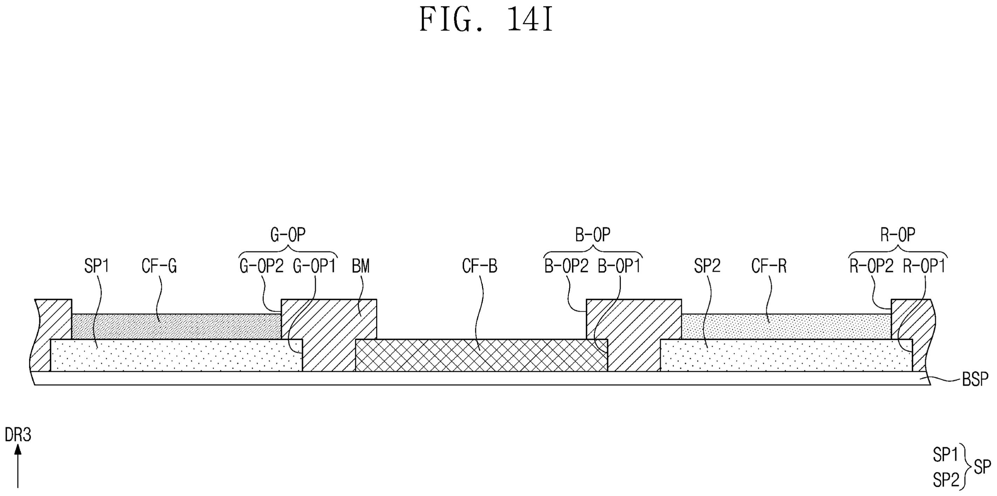

A third inner side surface of the light-blocking layer BM that defines a third opening R-OP may include a (3-1)-th portion overlapping the second scattering pattern SP2, and a (3-2)-th portion not overlapping the second scattering pattern SP2 in the direction perpendicular to the thickness direction. The third opening R-OP may include a (3-1)-th opening R-OP1 defined by the (3-1)-th portion, and a (3-2)-th opening R-OP2 defined by the (3-2)-th portion. The third color filter CF-R (see FIG. 14I) to be described later may be formed within the (3-2)-th opening R-OP2.

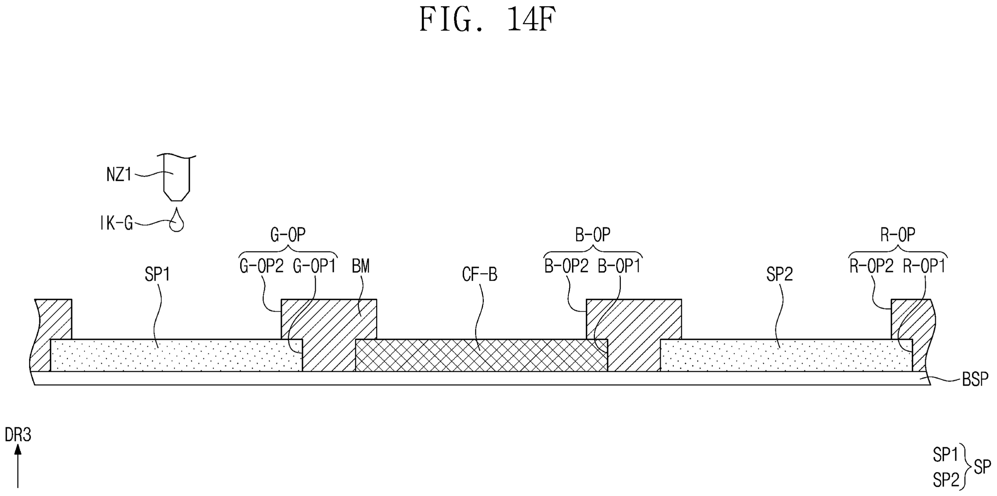

Referring to FIGS. 14F and 14G, a method for manufacturing a display device according to one or more embodiments includes an operation of forming a second color filter CF-G on a scattering pattern SP through an inkjet process. In the method for manufacturing the display device according to one or more embodiments, the operation of forming the second color filter CF-G may include an operation of providing a first ink IK-G into the second opening G-OP through an inkjet process, and then forming the second color filter CF-G by drying or curing the first ink IK-G.

The second color filter CF-G may be formed by providing the first ink IK-G into the second opening G-OP via a first nozzle NZ1. The first ink IK-G forming the second color filter CF-G may include a green pigment or a green dye.

The first ink IK-G may be provided on an inner side of a (2-2)-th opening G-OP2. The first ink IK-G may be located on the first scattering pattern SP1. The first ink IK-G may be directly provided on an upper surface of the first scattering pattern SP1 exposed by a (2-2)-th opening G-OP2. The first ink IK-G may be provided into the (2-2)-th opening G-OP2 through an inkjet process. The first ink IK-G provided into the (2-2)-th opening G-OP2 may be dried or cured. The first ink IK-G is dried or cured, and then the second color filter CF-G may be formed.

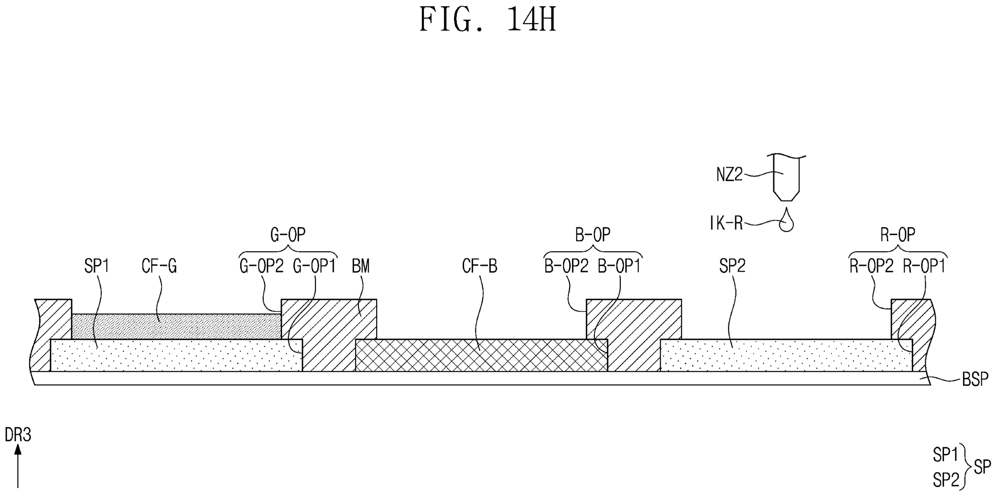

Referring to FIGS. 14H and 14I, a method for manufacturing a display device according to one or more embodiments may further include an operation of forming a third color filter CF-R on a scattering pattern SP through an inkjet process. In the method for manufacturing the display device according to one or more embodiments, the operation of forming the third color filter CF-R may include an operation of providing a second ink IK-R into the third opening R-OP through an inkjet process, and then forming the third color filter CF-R by drying or curing the second ink IK-R.

The third color filter CF-R may be formed by providing the second ink IK-R into the third opening R-OP via a second nozzle NZ2. The second ink IK-R from which the third color filter CF-R is formed may include a red pigment or a red dye.

The second ink IK-R may be provided on an inner side of a (3-2)-th opening R-OP2. The second ink IK-R may be located on the second scattering pattern SP2. The second ink IK-R may be directly provided on an upper surface of the second scattering pattern SP2 exposed by a (3-2)-th opening R-OP2. The second ink IK-R may be provided into the (3-2)-th opening R-OP2 through an inkjet process. The second ink IK-R provided into the (3-2)-th opening R-OP2 may be dried or cured. The second ink IK-R is dried or cured, and then the third color filter CF-R may be formed.

FIGS. 14F to 14I illustrate a case in which in the method for manufacturing the display device according to one or more embodiments, the second color filter CF-G is formed, and then the third color filter CF-R is formed. However, the present disclosure is not limited thereto, and it may be possible to change a formation order of the second color filter CF-G and the third color filter CF-R.

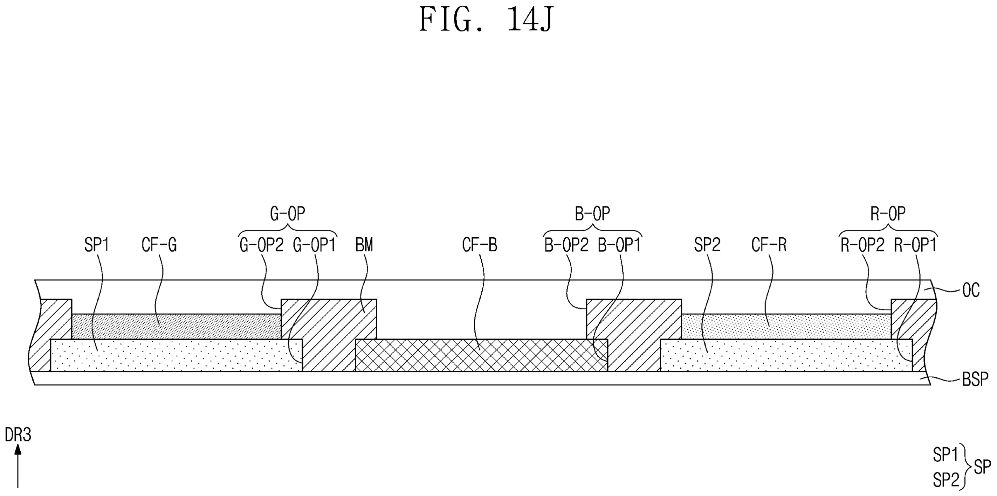

Referring to FIG. 14J, a method for manufacturing a display device according to one or more embodiments may further include an operation of forming an overcoat layer OC. After the operation of forming the second and third color filters CF-G and CF-R, an operation of forming the overcoat layer OC on the first to third color filters CF-B, CF-G, and CF-R may be performed.

The overcoat layer OC may be formed through various methods. The overcoat layer OC may be formed through various methods, such as vacuum deposition, spin coating, casting, Langmuir-Blodgett (LB), inkjet printing, laser printing, and laser induced thermal imaging (LITI). For example, the overcoat layer OC may be formed by coating a base resin composition on the first to third color filters CF-B, CF-G, and CF-R and then curing the resulting products. For example, a preliminary overcoat layer may be formed by providing the base resin composition on the first to third color filters CF-B, CF-G, and CF-R. In one or more embodiments, the base resin composition may include at least one of an epoxy resin, a phenol-based resin, or an acrylate-based resin, but the present disclosure is not limited thereto. Thereafter, the preliminary overcoat layer may be thermally cured or photocured to form the overcoat layer OC.

As illustrated in FIG. 14J, the overcoat layer OC may have a flat upper surface. The overcoat layer OC may reduce an operation between the first to third color filters CF-B, CF-G, and CF-R and the light-blocking layer BM. The overcoat layer OC is provided to reduce the operation between upper surfaces of the first to third color filters CF-B, CF-G, and CF-R and an upper surface of the light-blocking layer BM such that a functional layer located on the upper surfaces may be uniformly located. The overcoat layer OC may be located on each of the upper surfaces of the first to third color filters CF-B, CF-G, and CF-R and the upper surface of the light-blocking layer BM. The overcoat layer OC may contact each of the upper surfaces of the first to third color filters CF-B, CF-G, and CF-R, and the upper surface of the light-blocking layer BM.

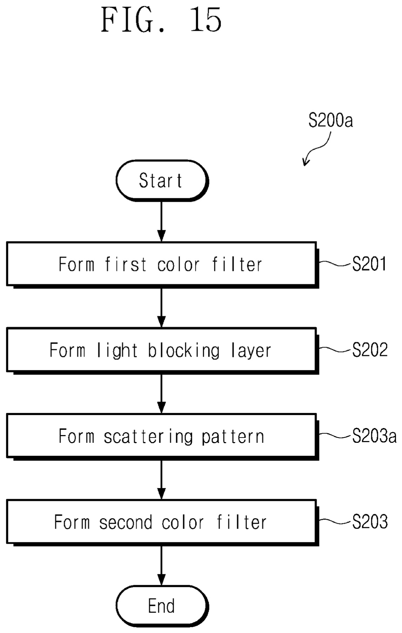

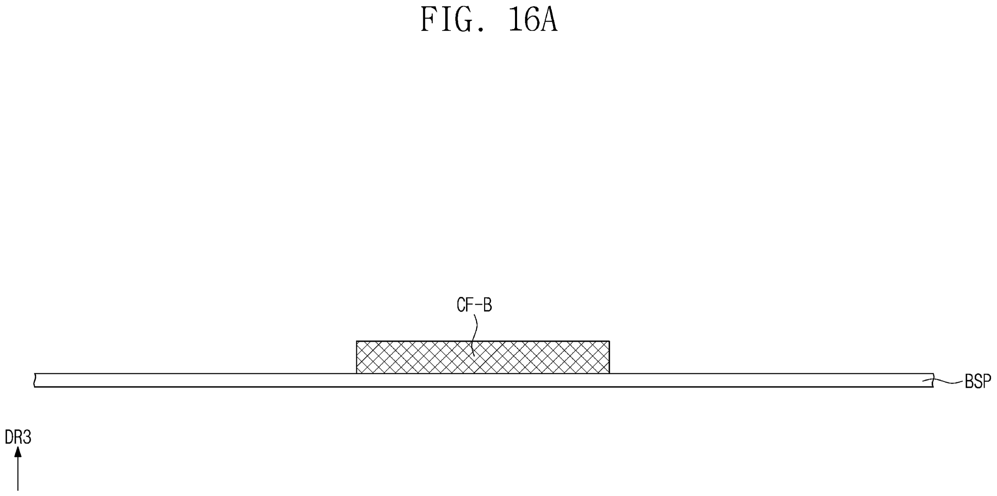

FIG. 15 is a flowchart of some operations in a method for manufacturing a display device according to one or more embodiments of the present disclosure. FIG. 15 is a flowchart of an operation of forming an optical layer (S200a) in the method for manufacturing the display device according to one or more embodiments of the present disclosure. FIG. 15 is a flowchart of one or more embodiments different from that of the operation of forming the optical layer according to one or more embodiments illustrated in FIG. 13 (S200). FIGS. 16A to 16H are cross-sectional views illustrating some operations in a method for manufacturing a display device according to one or more embodiments of the present disclosure. FIGS. 16A to 16H briefly illustrate some operations of forming an optical layer in the method for manufacturing a display device according to one or more embodiments. Hereinafter, when describing the method for manufacturing a display device according to one or more embodiments with reference to FIGS. 15, and 16A to 16H, the contents duplicated with those described above will not be explained again, and the following description will be mainly focused on the differences.

An operation of forming an optical layer according to one or more embodiments illustrated in FIG. 15 (S200a) differs from the operation of forming the optical layer described with reference to FIG. 13 (S200) in that an operation of forming a scattering pattern (S203a) is performed after the light-blocking layer BM is formed.

Referring to FIG. 15, the operation of forming the optical layer according to one or more embodiments (S200a) includes operations of: forming a first color filter overlapping a first light-emitting region by patterning a first preliminary color filter including a photosensitive material (S201); forming a light-blocking layer in which a first opening overlapping the first light-emitting region and a second opening overlapping a second light-emitting region are defined (S202); forming a scattering pattern overlapping the second light-emitting region (S203a); and forming a second color filter on the scattering pattern in the second opening through an inkjet process (S203).

Referring to FIG. 16A, after the first preliminary color filter P-CF-B (see FIG. 14A) is formed on a substrate BSP, the first color filter CF-B may be formed by patterning the first preliminary color filter P-CF-B (see FIG. 14A). The first color filter CF-B may be formed through a photolithography process.

The substrate BSP may be a member that provides a base surface on which the color filters CF-B, CF-G, and CF-R (see FIG. 10A) and the light-blocking layer BM (see FIG. 10A) are formed. The substrate BSP may provide a reference surface on which the color filters CF-B, CF-G, and CF-R (see FIG. 10A), the scattering patterns SP1 and SP2 (see FIG. 10A), and the light-blocking layer BM (see FIG. 10A) are formed. The substrate BSP may include the display panel DP illustrated in FIG. 10A, and the color filters CF-B, CF-G, and CF-R (see FIG. 10A), the scattering patterns SP1 and SP2 (see FIG. 10A), and the light-blocking layer BM (see FIG. 10A) may be formed on a reference surface that is provided from the uppermost layer of a plurality of functional layers included in the display panel DP (see FIG. 10A). For example, the color filters CF-B, CF-G, and CF-R (see FIG. 10A), the scattering patterns SP1 and SP2 (see FIG. 10A), and the light-blocking layer BM (see FIG. 10A) may be formed on a reference surface that is provided from the encapsulation layer TFE (see FIG. 10A) included in the display panel DP. Additionally, when the display panel DP (see FIG. 11B) further includes the touch sensor TS (see FIG. 11B), the color filters CF-B, CF-G, and CF-R (see FIG. 11B), the scattering patterns SP1 and SP2 (see FIG. 11B), and the light-blocking layer BM (see FIG. 11B) may also be formed on a reference surface that is provided from the touch sensor TS (see FIG. 11B).

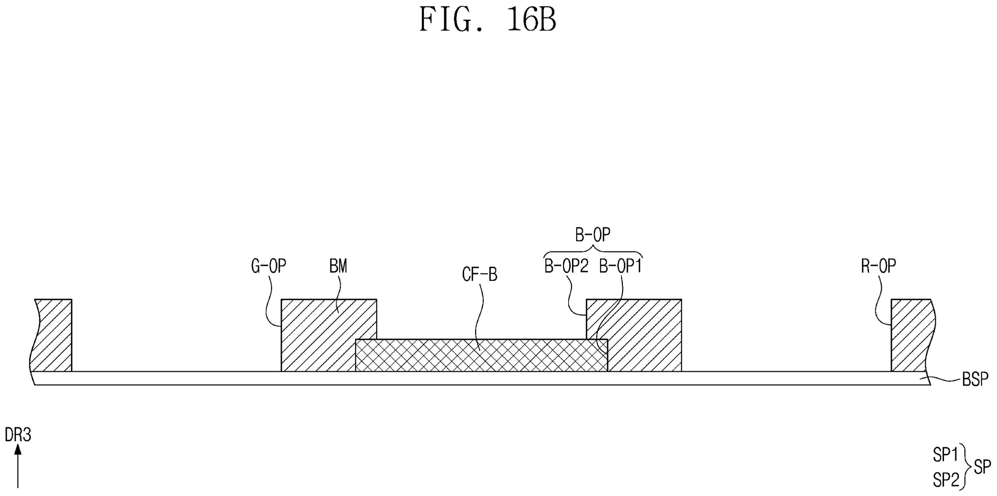

Referring to FIG. 16B, after the first color filter CF-B is formed, an operation of forming the light-blocking layer BM may be performed. The light-blocking layer BM in which the first to third openings B-OP, G-OP, and R-OP are defined may be formed on the substrate BSP. The light-blocking layer BM may be formed to partially overlap the first color filter CF-B on a plane. As illustrated in FIG. 16B, the light-blocking layer BM may partially cover an upper surface of the first color filter CF-B, and may be located on the first color filter CF-B. The light-blocking layer BM may partially contact the upper surface of the first color filter CF-B.

The first opening B-OP of the first to third openings B-OP, G-OP, and R-OP formed in (e.g., defined by) the light-blocking layer BM and overlapping the first color filter CF-B may be defined to have a plurality of portions. A first inner side surface of the light-blocking layer BM defining the first opening B-OP may include a (1-1)-th portion overlapping the first color filter CF-B, and a (1-2)-th portion not overlapping the first color filter CF-B in the direction perpendicular to the thickness direction. The first opening B-OP may include a (1-1)-th opening B-OP1 defined by the (1-1)-th portion, and a (1-2)-th opening B-OP2 defined by the (1-2)-th portion.

Second and third inner side surfaces of the light-blocking layer BM, which respectively define the second and third openings G-OP and R-OP, may define one continuous surface in a direction of getting farther away from the substrate BSP. For example, the second and third inner side surfaces may define one continuous surface along the third direction DR3.

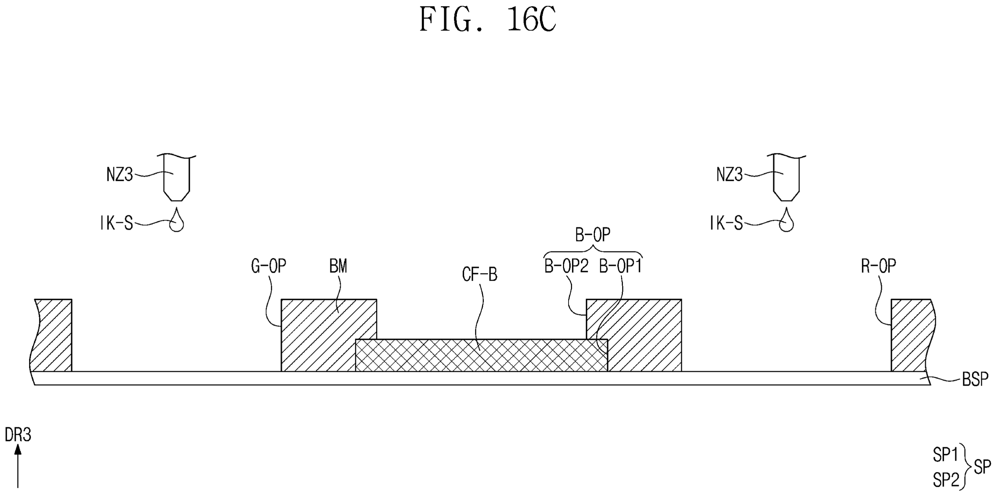

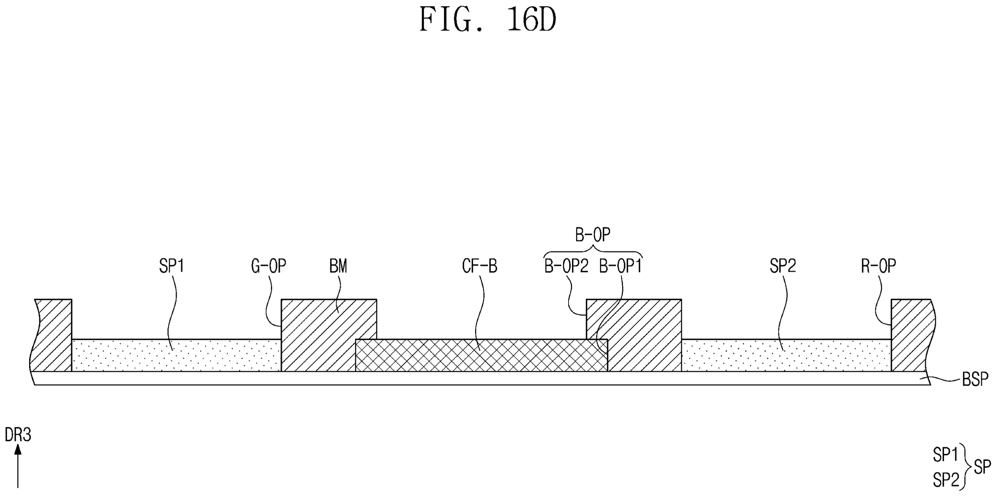

Referring to FIGS. 16C and 16D, a method for manufacturing a display device according to one or more embodiments includes an operation of forming a scattering pattern SP. In the method for manufacturing the display device according to one or more embodiments described with reference to FIGS. 16A to 16H, the operation of forming the scattering pattern (S203a) (see FIG. 15) may be performed after the operation of forming the light-blocking layer BM. The operation of forming the scattering pattern (S203a) (see FIG. 15) may be performed after the operation of forming the light-blocking layer BM and before the operation of forming the second and third color filters CF-G and CF-R.

Referring to FIG. 16C, the operation of forming the scattering pattern SP includes an operation of providing a scattering composition IK-S including scattering particles into each of the second and the third openings G-OP and R-OP. The scattering patterns SP1 and SP2 may be formed by providing the scattering composition IK-S into the second and third openings G-OP and R-OP via a third nozzle NZ3.

The scattering composition for forming the scattering patterns SP1 and SP2 may include a base resin and scattering particles dispersed in a base resin. The base resin is a medium in which the scattering particles are dispersed, and may be composed of various resin compositions capable of generally being referred to as a binder. The base resin may be an acrylate-based resin, a urethane-based resin, a silicone-based resin, an epoxy-based resin, etc. The base resin may be a resin selected for performing an inkjet process.

As illustrated in FIG. 16C, the scattering composition IK-S may be provided into each of the second opening G-OP and the third opening R-OP. For example, the scattering composition IK-S may be provided on an inner side of each of the second opening G-OP and the third opening R-OP through an inkjet process.

Referring to FIGS. 16C and 16D together, the scattering composition IK-S provided into each of the second and third openings G-OP and R-OP may be dried or cured. The scattering composition IK-S provided into each of the second and third openings G-OP and R-OP may be dried or cured to form the scattering patterns SP1 and SP2. The scattering composition IK-S provided into the second opening G-OP may be dried or cured to form the first scattering pattern SP1. The scattering composition IK-S provided into the third opening R-OP may be dried or cured to form the second scattering pattern SP2.

The scattering patterns SP1 and SP2 formed through the method for manufacturing the display device according to one or more embodiments might not overlap the light-blocking layer BM on a plane. The light-blocking layer BM might not overlap each of the first scattering pattern SP1 and the second scattering pattern SP2 on a plane. The light-blocking layer BM may not be located on upper surfaces of the first and second scattering patterns SP1 and SP2. As illustrated in FIG. 16D, the light-blocking layer BM may contact only side surfaces of each of the first and second scattering patterns SP1 and SP2, and might not contact the upper surfaces of each of the first and second scattering patterns SP1 and SP2.

FIGS. 16C and 16D illustrate a case in which the first scattering pattern SP1 and the second scattering pattern SP2 are formed through the same process, but the present disclosure is not limited thereto. In the method for manufacturing the display device according to one or more embodiments, the first scattering pattern SP1 and the second scattering pattern SP2 may be formed through a separate process. In one or more embodiments, the operation of forming the scattering patterns SP1 and SP2 (S203a) may include operations of: forming the first scattering pattern SP1 overlapping the second light-emitting region PXA-G; and forming the second scattering pattern SP2 overlapping the third light-emitting region PXA-R. An order of the operations of forming the first scattering pattern SP1 and forming the second scattering pattern SP2 is not limited to any one embodiment.

For example, the operation of forming the scattering patterns SP1 and SP2 may include operations of: providing a first scattering composition including first scattering particles into the second opening G-OP; providing a second scattering composition including second scattering particles into the third opening R-OP; and drying or curing the first scattering composition and the second scattering composition. The first scattering particles included in the first scattering composition for forming the first scattering pattern SP1 may be the same as or different from the second scattering particles included in the second scattering composition for forming the second scattering pattern SP2. Also, the first scattering particles and the second scattering particles included in the respective first scattering pattern SP1 and second scattering pattern SP2 may have the same content or different contents.

In the method for manufacturing the display device according to one or more embodiments, the scattering patterns SP1 and SP2 may be formed through an inkjet process. When the scattering patterns SP1 and SP2 are formed through an inkjet process, it may be possible to control the coated amount of a scattering composition according to pixel areas of the second light-emitting region PXA-G and the third light-emitting region PXA-R, which are the light-emitting regions in which the scattering patterns SP1 and SP2 are formed. Unlike a photolithography process, when the scattering patterns SP1 and SP2 are formed through an inkjet process, the coated amount of a scattering composition may be appropriately controlled according to a size of the light-emitting region, which may be advantageous in adjusting a viewing angle and reflectivity.

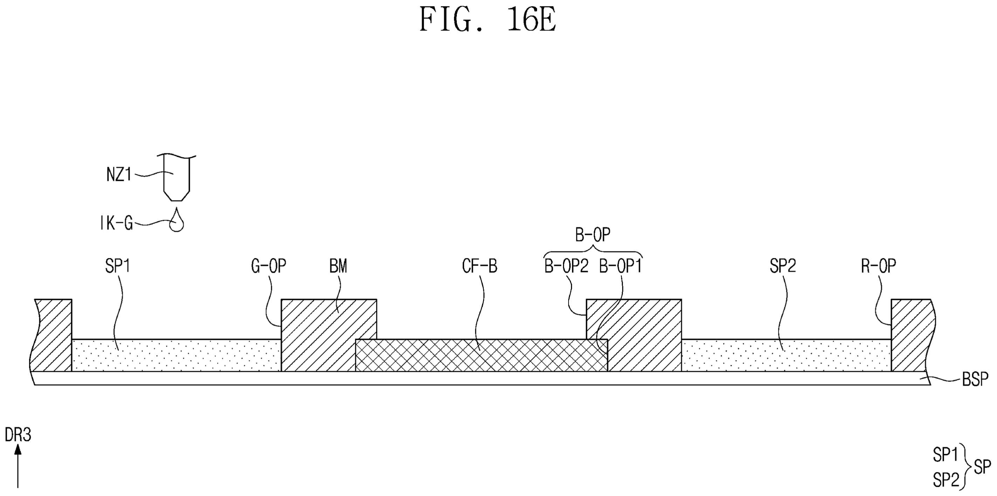

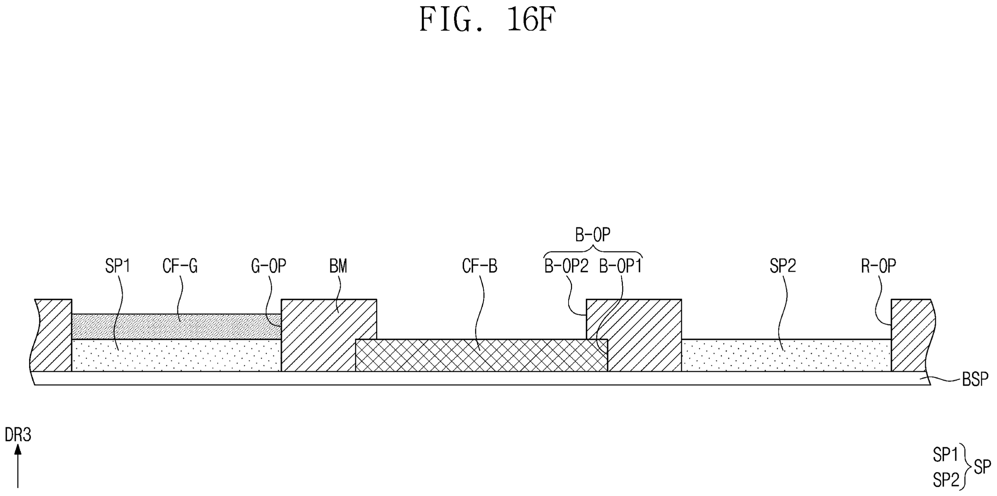

Referring to FIGS. 16E and 16F, a method for manufacturing a display device according to one or more embodiments includes an operation of forming a second color filter CF-G on a scattering pattern SP through an inkjet process. In the method for manufacturing the display device according to one or more embodiments, the operation of forming the second color filter CF-G may include an operation of providing a first ink IK-G into the second opening G-OP through an inkjet process, and then forming the second color filter CF-G by drying or curing the first ink IK-G.

The second color filter CF-G may be formed by providing the first ink IK-G into the second opening G-OP via a first nozzle NZ1. The first ink IK-G may include a green pigment or a green dye.

The first ink IK-G may be provided on the first scattering pattern SP1. The first ink IK-G may be directly provided on an upper surface of the first scattering pattern SP1 exposed by the second opening G-OP. The entire upper surface of the first scattering pattern SP1 may be exposed by the second opening G-OP, and the first ink IK-G may be provided to the entire exposed upper surface of the first scattering pattern SP1. The first ink IK-G provided into the second opening G-OP may be dried or cured. The first ink IK-G is dried or cured, and then the second color filter CF-G may be formed.

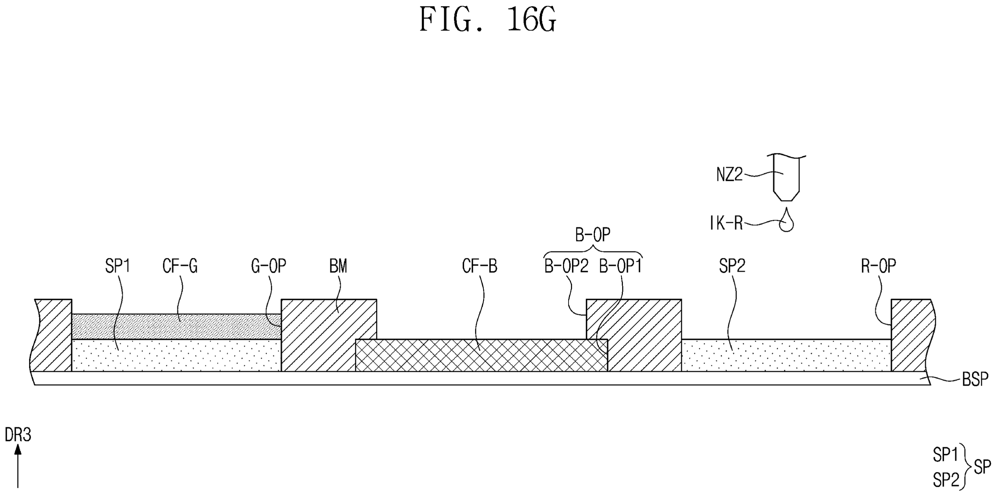

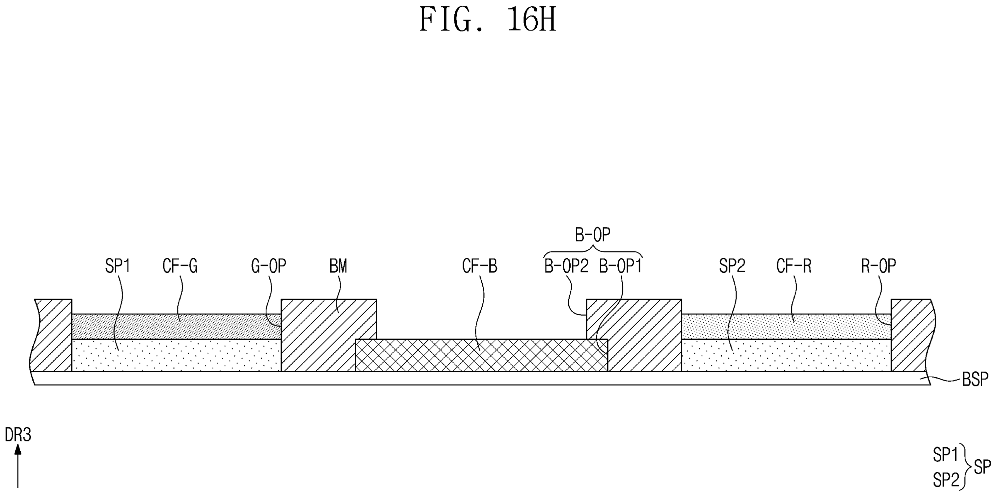

Referring to FIGS. 16G and 16H, a method for manufacturing a display device according to one or more embodiments may further include an operation of forming a third color filter CF-R on a scattering pattern SP through an inkjet process. In the method for manufacturing the display device according to one or more embodiments, the operation of forming the third color filter CF-R may include an operation of providing a second ink IK-R into the third opening R-OP through an inkjet process, and then forming the third color filter CF-R by drying or curing the second ink IK-R.

The third color filter CF-R may be formed by providing the second ink IK-R into the third opening R-OP via a second nozzle NZ2. The second ink IK-R may include a red pigment or a red dye.

The second ink IK-R may be located on the second scattering pattern SP2. The second ink IK-R may be directly provided on an upper surface of the second scattering pattern SP2 exposed by the third opening R-OP. The entire upper surface of the second scattering pattern SP2 may be exposed by the third opening R-OP, and the second ink IK-R may be provided to the entire exposed upper surface of the second scattering pattern SP2. The second ink IK-R provided into the third opening R-OP may be dried or cured. The second ink IK-R is dried or cured, and then the third color filter CF-R may be formed.

FIGS. 16E to 16H illustrate a case in which in the method for manufacturing the display device according to one or more embodiments, the second color filter CF-G is formed, and then the third color filter CF-R is formed. However, the present disclosure is not limited thereto, and it may be possible to change a formation order of the second color filter CF-G and the third color filter CF-R.

In one or more embodiments, an operation of forming the overcoat layer OC (see FIG. 14J) on the first to third color filters CF-B, CF-G, and CF-R may be further performed after the operation of forming the second and third color filters CF-G and CF-R. The contents described with reference to FIG. 14J may be similarly applied to the operation of forming the overcoat layer OC (see FIG. 14J).

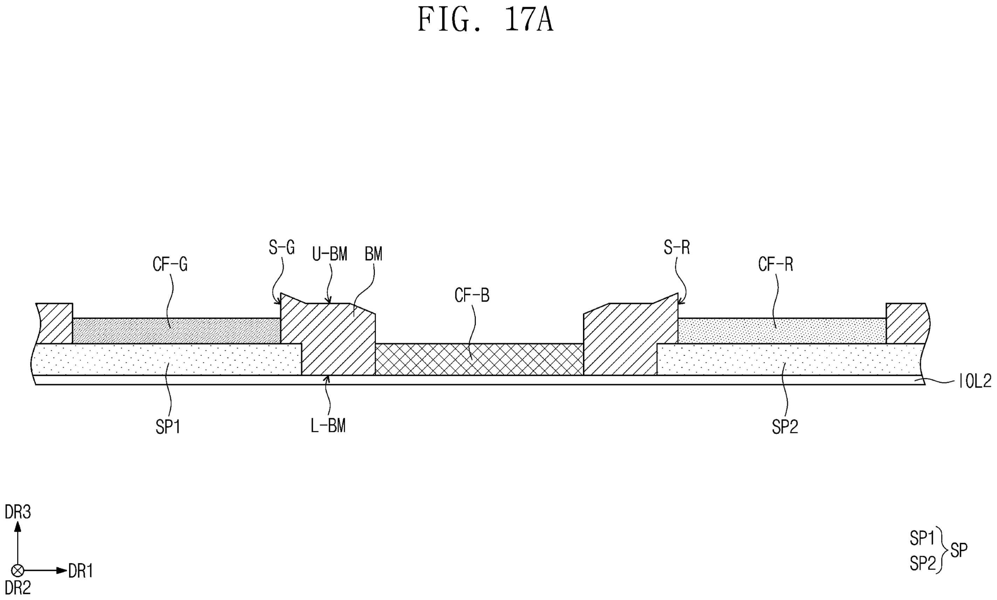

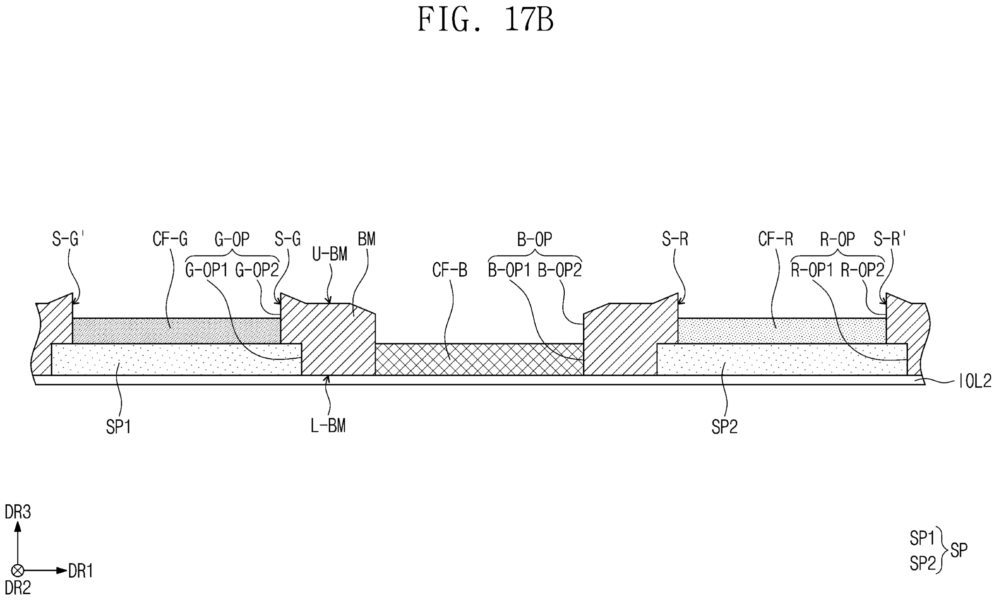

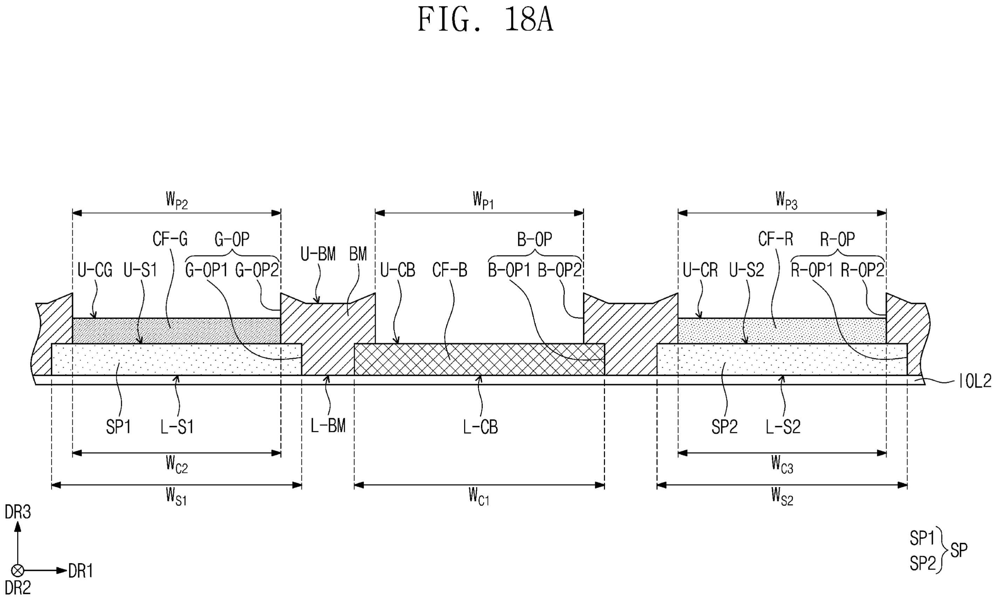

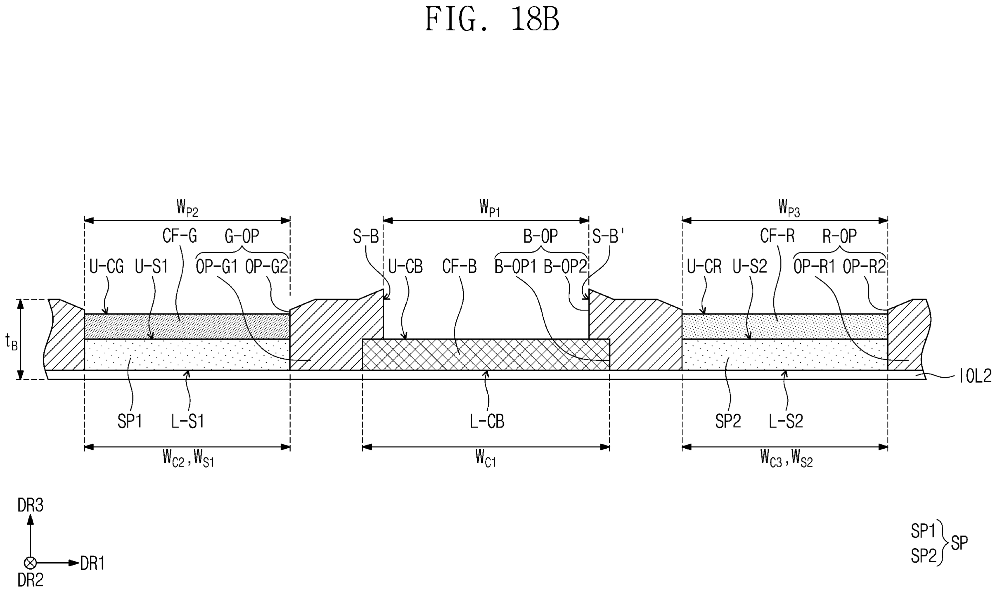

FIGS. 17A and 17B are cross-sectional views for describing limitation that may occur in a display module according to Comparative Example. FIGS. 18A and 18B are cross-sectional views of some components of a display module according to one or more embodiments of the present disclosure. FIGS. 17A, 17B, 18A, and 18B respectively illustrate cross sections taken along the line III-III' of FIG. 5, focusing on the components included in an optical layer PP among the components included in the display module. Hereinafter, in the description of a display module according to Comparative Example and Example with reference to FIGS. 17A, 17B, 18A, and 18B, the same reference numerals or symbols are used for the components duplicated with those described with reference to FIGS. 1 to 11B, etc., and a detailed description thereof will be omitted.

A display module of FIGS. 17A and 17B differs from the display module illustrated in FIGS. 9A and 9B in that a first color filter is formed through not a photolithography process but an inkjet process. That is, the display module according to Comparative Example illustrated in FIGS. 17A and 17B corresponds to a case in which all the first to third color filters CF-B, CF-G, and CF-R (see FIG. 9A) are formed through an inkjet process.

FIG. 17A illustrates a display module according to Comparative Example 1, and the display module corresponds to a case in which the first and second scattering patterns SP1 and SP2 are formed to have an integral shape in the second light-emitting region PXA-G (see FIG. 9A) and the third light-emitting region PXA-R (see FIG. 9A). FIG. 17B illustrates a display module according to Comparative Example 2, and compared to the display module according to Comparative Example 1, the display module corresponds to a case in which the first and second scattering patterns SP1 and SP2 are respectively patterned in the second light-emitting region PXA-G (see FIG. 9A) and the third light-emitting region PXA-R (see FIG. 9A).

When the scattering patterns are applied to a color filter substrate, a light-blocking layer may include a horn-shaped operation formed by partially overlapping an adjacent scattering pattern in a non-light-emitting region. The horn-shaped operation may mean an operation formed between the center portion and the edge portion of the light-blocking layer. That is, the horn-shaped operation may mean a difference between the shortest distance from the center portion of an upper surface of a substrate, which is a member of the light-blocking layer, to the center portion of an upper surface of the light-blocking layer, and the shortest distance from an edge portion of the upper surface of the substrate to an edge portion of the upper surface of the light-blocking layer. Generally, at an overlapping portion in which the light-blocking layer overlaps an adjacent scattering pattern, a horn-shaped operation may be caused in an upward direction by partially overlapping adjacent two components, compared to the other region in which the two adjacent components do not overlap.

Referring to FIG. 17A, a light-blocking layer BM is formed on the scattering patterns SP1 and SP2 to be partially overlapped. Accordingly, the horn-shaped operation may be formed at a portion of the light-blocking layer BM that overlaps an adjacent scattering pattern in the non-light-emitting region. For example, a first horn-shaped operation S-G may be caused by an increase in a film thickness at an end adjacent to the first scattering pattern SP1 in the light-blocking layer BM formed between the first light-emitting region PXA-B (see FIG. 9A) and the second light-emitting region PXA-G (see FIG. 9A). A second horn-shaped operation S-R may be caused by an increase in a film thickness at an end adjacent to the second scattering pattern SP2 in the light-blocking layer BM formed between the first light-emitting region PXA-B (see FIG. 9A) and the third light-emitting region PXA-R (see FIG. 9A).

As illustrated in FIG. 17A, when the scattering patterns SP1 and SP2 are formed by overlapping only corresponding light-emitting regions, the horn-shaped operations S-G and S-R occur at overlapping portions adjacent to the light-emitting regions in which the scattering patterns SP1 and SP2 are formed, and thus a shape variation of the light-blocking layer BM may increase. When a shape variation of the light-blocking layer BM increases, ink accumulation, etc., occur during a subsequent inkjet process, which results in a deterioration of coating uniformity.

As illustrated in FIG. 17B, a method of patterning the scattering patterns SP1 and SP2 corresponding to light-emitting regions may be used for reducing the shape variation of the light-blocking layer BM. However, in this case, cracks occur during the curing process due to a difference in pinning points between the first light-emitting region PXA-B (see FIG. 9A) in which scattering patterns SP are not located and the second and third light-emitting regions PXA-G and PXA-R (see FIG. 9A) in which scattering patterns SP are located.

The light-blocking layer BM may be formed by including a lyophobic material so as to reduce or prevent leakage of an ink for a color filter formation out of the opening of the light-blocking layer BM. For example, the light-blocking layer BM may be formed so as to include a lyophilic region that is formed at lower inner parts of the openings B-OP, G-OP, and R-OP, and a lyophobic region that is formed at upper inner parts of the openings B-OP, G-OP, and R-OP. The ink discharged into the inner parts of the openings B-OP, G-OP, and R-OP of the light-blocking layer BM may be prevented from leaking out of the lyophilic region with respect to the pinning point corresponding to a boundary between the lyophilic region and the lyophobic region, and the color filters CF-B, CF-G, and CF-R may be formed in the lyophilic region positioned in a lower part of the pinning point through the drying process. When the pinning point varies according to each of pixel regions, cracks occur during the curing process, which may lead to the degradation in display quality of a display device.

As illustrated in FIG. 17B, as the first scattering pattern SP1 is patterned so as to correspond to the second light-emitting region PXA-G (see FIG. 9A), and the second scattering pattern SP2 is patterned so as to correspond to the third light-emitting region PXA-R (see FIG. 9A), horn-shaped operations S-G' and S-R' are formed at ends adjacent to the first and second scattering patterns SP1 and SP2 also in the light-blocking layer BM formed between the second light-emitting region PXA-G (see FIG. 9A) and the third light-emitting region PXA-R (see FIG. 9A), and thus the shape variation of the light-blocking layer BM may be reduced overall. However, even in this case, because it is difficult to completely control a difference between a shape at the end of the light-blocking layer BM adjacent to the first light-emitting region PXA-B (see FIG. 9A) in which the scattering pattern SP is not located and a shape at the ends of the light-blocking layer BM adjacent to the second and third light-emitting regions PXA-G and PXA-R (see FIG. 9A) in which the scattering pattern SP is located, a difference in pinning points between the light-emitting regions occurs, which may cause cracks, etc., while curing the ink. According to one or more embodiments of the present disclosure, because a color filter that is formed in a light-emitting region in which a scattering pattern is not located is formed through a photolithography process, it may be possible to form patterns with high-resolution and reduce a variation of a horn-shaped operation that occurs at an overlapping portion between a scattering pattern and a light-blocking layer, and thus the coating uniformity of the ink may be improved during an inkjet process.

With the development of high-resolution display devices, the number of pixels may be increased, and a size of a single pixel may be decreased. Accordingly, an inkjet process of forming color filters in a high-resolution display device is becoming challenging, and there is a limitation in forming color filters that correspond to all light-emitting regions through the inkjet process. According to one or more embodiments of the present disclosure, a high-resolution color filter may be achieved by combining a photolithography process and an inkjet process and using the combined process when forming a color filter.

Additionally, in one or more embodiments of the present disclosure, the color filter in the light-emitting region in which the scattering patterns SP1 and SP2 are not located is formed through a photolithography process at the same height level as those of the scattering patterns SP1 and SP2, and thus it may be possible to alleviate a shape variation between a horn-shaped operation at overlapping portions adjacent to the light-emitting regions in which the scattering patterns SP1 and SP2 are formed and a horn-shaped operation at overlapping portions adjacent to the light-emitting regions in which the scattering patterns SP1 and SP2 are not formed. Referring to FIG. 18A, the first color filter CF-B that is located in the first light-emitting region PXA-B (see FIG. 9A) is formed through a photolithography process at the same height level as those of the scattering patterns SP1 and SP2, and thus it may be possible to alleviate a shape variation of horn-shaped operations at overlapping portions adjacent to each of the first to third light-emitting regions PXA-B, PXA-G, and PXA-R (see FIG. 9A). As the shape variation of the horn-shaped operations at the overlapping portions is alleviated, ink accumulation phenomenon may be reduced or prevented during an inkjet process, and thus coating uniformity may be improved. Furthermore, because the light-emitting regions have the same pinning point, a pattern may be formed to have improved thickness uniformity, and thus defects in display quality may be reduced or prevented.

Besides, in one or more embodiments of the present disclosure, as the first color filter CF-B is formed through a photolithography process, even when all the remaining scattering patterns SP1 and SP2 and the color filters CF-G and CF-R are formed through an inkjet process, a pattern may be formed to have a substantially uniform thickness because the second and third light-emitting regions PXA-G and PXA-R (see FIG. 9A) to which ink is provided have the same pinning point. Referring to FIG. 18B, the light-blocking layer BM may be formed on the first color filter CF-B formed through a photolithography process to be partially overlapped. In the light-blocking layer BM, horn-shaped operations S-B and S-B' may be formed at a portion overlapping the first color filter CF-B. Accordingly, it is likely to cause a difference between a shape at an end of the light-blocking layer BM adjacent to the first light-emitting region PXA-B (see FIG. 9A) in which the scattering pattern SP is not located and a shape at an end of the light-blocking layer adjacent to the second and third light-emitting regions PXA-G and PXA-R (see FIG. 9A) in which the scattering pattern SP is located. However, because the first color filter CF-B is formed through not an inkjet process but a photolithography process, defects due to a difference in pinning points may not occur.

A display device according to one or more embodiments of the present disclosure includes a first color filter overlapping a first light-emitting region, a scattering pattern and a second color filter overlapping a second light-emitting region, and a light-blocking layer located between the first color filter and the second color filter, and the light-blocking layer is formed to partially cover an upper surface of the first color filter. The first color filter may be formed at the same layer as a scattering pattern through a photolithography process before forming the light-blocking layer. Accordingly, a horn-shaped operation of the light-blocking layer formed at each of overlapping portions between the light-emitting regions may have a reduced variation. The first color filter formed in the light-emitting region in which the scattering pattern is not located is formed at the same layer as the scattering pattern through a photolithography process, and thus the horn-shaped operation of the light-blocking layer formed at each of the overlapping portions between light-emitting regions may have a reduced variation. In other words, in conventional structures, the light-blocking layer formed at the boundary between adjacent light-emitting regions tends to exhibit a horn-shaped profile due to the height difference caused by overlapping of the scattering pattern and other functional layers. Such profile variation may lead to non-uniform ink flow in a subsequent inkjet process. According to the present disclosure, when a scattering pattern is not provided in a given light-emitting region, the first color filter in that region is formed in the same layer as the scattering pattern through a photolithography process. By aligning the formation of the color filter and the scattering pattern within a common plane, the step height at the overlapping portions with the light-blocking layer is reduced, and the horn-shaped variation of the light-blocking layer is minimized. As a result, the overall uniformity of the coating process and the printing accuracy are improved. In certain embodiments, the scattering pattern is omitted from the blue light-emitting region. Because the blue color filter inherently exhibits lower transmittance, the optical benefit of introducing a scattering structure is limited. In addition, omitting the scattering pattern in the blue subpixel reduces step height differences at the boundary of the light-blocking layer, thereby minimizing horn-shaped variation. The blue color filter is nevertheless formed in the same layer as the scattering patterns of the other subpixels through a photolithography process, such that the overall layer height remains consistent across the pixel array. As a result, uniformity of the coating and stability of the subsequent inkjet printing process are improved, while maintaining the desired color performance.

A display device and an electronic device according to one or more embodiments include an optical layer that is located on a display panel and includes color filters, and the optical layer includes a scattering pattern located in a corresponding light-emitting region to increase light emission efficiencies, and to reduce color differences according to a viewing angle.

A method for manufacturing a display device according to one or more embodiments includes an operation of forming, through a photolithography process, a color filter located in a light-emitting region in which a scattering pattern is not formed, thereby making it possible to implement the display device with high resolution and to contribute to improving process efficiency during a manufacturing process.

In the above, description has been made with reference to embodiments of the present disclosure, but those skilled or of ordinary skill in the art may understand that various modifications and changes may be made to the present disclosure insofar as such modifications and changes do not depart from the technical scope of the present disclosure set forth in the claims to be described later.

Therefore, the technical scope of the present disclosure is not to be limited to the contents stated in the detailed description of the specification, but should be determined by the claims, with functional equivalents thereof to be included therein.

## Claims

1. A display device (DD) comprising:
a base layer (BS) comprising a non-display region (NDA), and a display region (DA) that comprises a first light-emitting region (PXA-B), a second light-emitting region (PXA-G), and a non-light-emitting region (NPXA);
a display element layer (EDL) above the base layer (BS) and comprising a light-emitting element (ED); and
an optical layer (PP) above the display element layer (EDL) and comprising:
a first color filter (CF-B) overlapping the first light-emitting region (PXA-B);
a scattering pattern (SP1, SP2) overlapping the second light-emitting region (PXA-G) and comprising scattering particles;
a second color filter (CF-G) overlapping the second light-emitting region (PXA-G) above the scattering pattern (SP1, SP2); and
a light-blocking layer (BM) overlapping the non-light-emitting region (NPXA) between the first color filter (CF-B) and the second color filter (CF-G), and partially covering an upper surface (U-CB) of the first color filter (CF-B).

2. The display device (DD) of claim 1, wherein the light-blocking layer (BM) is not above the second color filter (CF-G); and/or wherein the scattering pattern (SP1, SP2) does not overlap the first light-emitting region (PXA-B).

3. The display device (DD) of claim 1 or 2, wherein the scattering pattern (SP1, SP2) further comprises a photosensitive material; and/or wherein at least two of a lower surface (L-CB) of the first color filter (CF-B), a lower surface (L-S1, L-S2) of the scattering pattern (SP1, SP2), and a lower surface (L-BM) of the light-blocking layer (BM) are coplanar.

4. The display device (DD) of any one of claim 1 to 3, wherein the scattering pattern (SP1, SP2) is spaced apart from the first color filter (CF-B) with the light-blocking layer (BM) between the scattering pattern (SP1, SP2) and the first color filter (CF-B); and/or wherein a thickness variation of the first color filter (CF-B) is less than a thickness variation of the second color filter (CF-G).

5. The display device (DD) of any one of claims 1 to 4, wherein a first opening (BOP) corresponding to the first light-emitting region (PXA-B), and a second opening (G-OP) corresponding to the second light-emitting region (PXA-G) are defined in the light-blocking layer (BM), and
wherein, in a first direction (DR1) perpendicular to a thickness direction,
a width of the first color filter (CF-B) is greater than a width of the first opening (B-OP), and/or
a width of the second color filter (CF-G) is substantially equal to a width of the second opening (G-OP), and/or
a width of the scattering pattern (SP1, SP2) is substantially equal to or greater than a width of the second opening (G-OP).

6. The display device (DD) of any one of claims 1 to 5, wherein the first light-emitting region (PXA-B) is configured to emit light having a first wavelength, and
wherein the second light-emitting region (PXA-G) is configured to emit light having a second wavelength that is longer than the first wavelength.

7. The display device (DD) of any one of claims 1 to 6, wherein the display region (DA) further comprises a third light-emitting region (PXA-R),
wherein the scattering pattern (SP1, SP2) overlaps the second light-emitting region (PXA-G) and the third light-emitting region (PXA-R), and
wherein the optical layer (PP) further comprises a third color filter (CF-R) overlapping the third light-emitting region (PXA-R) above the scattering pattern (SP1, SP2).

8. The display device (DD) of claim 7, wherein the scattering pattern (SP1, SP2) comprises:
a first scattering pattern (SP1) overlapping the second light-emitting region (PXA-G); and
a second scattering pattern (SP2) overlapping the third light-emitting region (PXA-R) and spaced apart from the first scattering pattern (SP1) with the light-blocking layer (BM) between the first scattering pattern (SP1) and the second scattering pattern (SP2).

9. The display device (DD) of any one of claims 1 to 8, further comprising an encapsulation layer (TFE) between the display element layer (EDL) and the optical layer (PP).

10. The display device (DD) of claim 9, wherein the scattering pattern (SP1, SP2) and the first color filter (CF-B) are directly on the encapsulation layer (TFE), and/or
wherein the second color filter (CF-G) is directly on the scattering pattern (SP1, SP2).

11. The display device (DD) of claim 9 or 10, further comprising a touch sensor (TS) between the encapsulation layer (TFE) and the optical layer (PP).

12. The display device (DD) of any one of claims 1 to 11, wherein the optical layer (PP) further comprises an overcoat layer (OC) covering an upper surface (U-CB) of the first color filter (CF-B), an upper surface (U-CG) of the second color filter (CF-G), and an upper surface (U-BM) of the light-blocking layer (BM).

13. An electronic device (EE) comprising:
a display module (DM) comprising a display panel (DP), and an optical layer (PP) above the display panel (DP); and
a housing (HAU) accommodating the display module (DM),
wherein the display panel (DP) comprises:
a base layer (BS) comprising a non-display region (NDA), and a display region (DA) that comprises a first light-emitting region (PXA-B), a second light-emitting region (PXA-G), and a non-light-emitting region (NPXA); and
a display element layer (EDL) above the base layer (BS) and comprising a light-emitting element (ED),
wherein the optical layer (PP) comprises:
a first color filter (CF-B) overlapping the first light-emitting region (PXA-B);
a scattering pattern (SP1, SP2) overlapping the second light-emitting region (PXA-G) and comprising scattering particles;
a second color filter (CF-G) overlapping the second light-emitting region (PXA-G) above the scattering pattern (SP1, SP2); and
a light-blocking layer (BM) overlapping the non-light-emitting region (NPXA) between the first color filter (CF-B) and the second color filter (CF-G), and covering, at least partially, an upper surface (U-CB) of the first color filter (CF-B).

14. A method for manufacturing a display device (DD), the method comprising:
preparing (S100) a substrate defining a first light-emitting region (PXA-B) and a second light-emitting region (PXA-G); and
forming (S200, S200a) an optical layer (PP) above the substrate by:
forming (S201) a first color filter (CF-B) overlapping the first light-emitting region (PXA-B) by patterning a first preliminary color filter (P-CF-B) comprising a photosensitive material;
forming (S201a, S203a) a scattering pattern (SP1, SP2) overlapping the second light-emitting region (PXA-G);
forming (S202) a light-blocking layer (BM) defining a first opening (B-OP) overlapping the first light-emitting region (PXA-B), and a second opening (G-OP) overlapping the second light-emitting region (PXA-G); and
forming (S203) a second color filter (CF-G) above the scattering pattern (SP1, SP2) in the second opening (G-OP) through an inkjet process.

15. The method of claim 14, wherein the forming (S201a) of the scattering pattern (SP1, SP2) is before the forming (S202) of the light-blocking layer (BM), and comprises forming a preliminary scattering pattern (P-SP) comprising a photosensitive material and scattering particles, and patterning the preliminary scattering pattern (P-SP); or
wherein the forming (S201a) of the scattering pattern (SP1, SP2) is after the forming (S202) of the light-blocking layer (BM), and comprises providing, within the second opening, a scattering composition comprising scattering particles before the forming of the second color filter (CF-G).
